(19) **Europäisches Patentamt / European Patent Office / Office européen des brevets**

(11) **EP 3 311 394 B1**

(12) **FASCICULE DE BREVET EUROPEEN**

(45) Date de publication et mention de la délivrance du brevet:
**19.01.2022   Bulletin 2022/03**

(21) Numéro de dépôt: **16731090.3**

(22) Date de dépôt: **16.06.2016**

(51) Classification Internationale des Brevets (IPC):
*H01L 21/20* (2006.01)

(52) Classification Coopérative des Brevets (CPC):
**H01L 21/02647; C30B 25/186; C30B 29/403; H01L 21/02381; H01L 21/0243; H01L 21/02433; H01L 21/02458; H01L 21/0254; H01L 21/02639; H01L 21/02658; H01L 33/007; H01L 33/16**

(86) Numéro de dépôt international:
**PCT/EP2016/063824**

(87) Numéro de publication internationale:
**WO 2016/202899 (22.12.2016 Gazette 2016/51)**

(54) **PROCÉDÉ PERMETTANT D'OBTENIR SUR UN SUBSTRAT CRISTALLIN UNE COUCHE SEMI-POLAIRE DE NITRURE DE GROUPE III**

VERFAHREN FÜR DEN ERHALT EINER SEMIPOLAREN III-NITRIDSCHICHT AUF EINEM KRISTALLINEN SUBSTRAT

METHOD FOR OBTAINING ON A CRYSTALLINE SUBSTRATE A SEMI-POLAR LAYER OF III-NITRIDE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.06.2015   FR 1555582**
**30.11.2015   FR 1561618**

(43) Date de publication de la demande:
**25.04.2018   Bulletin 2018/17**

(73) Titulaires:
- **Commissariat à l'Énergie Atomique et aux Énergies Alternatives**
  **75015 Paris (FR)**
- **Centre National de la Recherche Scientifique**
  **75016 Paris (FR)**

(72) Inventeurs:
- **EL KHOURY MAROUN, Michel**
  **06600 Antibes (FR)**
- **FEUILLET, Guy**
  **38410 Saint-martin D'uriage (FR)**
- **VENNEGUES, Philippe**
  **06600 Antibes (FR)**
- **ZUNIGA PEREZ, Jesus**
  **06410 Biot (FR)**

(74) Mandataire: **Marks & Clerk France**
**Immeuble "Visium"**
**22, avenue Aristide Briand**
**94117 Arcueil Cedex (FR)**

(56) Documents cités:
EP-A2- 2 136 390       US-A1- 2011 045 658
US-A1- 2012 135 557    US-A1- 2012 276 722

- CHIU CHING-HSUEH ET AL: "Growth of semi-polar GaN-based light-emitting diodes grown on an patterned Si substrate", GALLIUM NITRIDE MATERIALS AND DEVICES VI, SPIE, 1000 20TH ST. BELLINGHAM WA 98225-6705 USA, vol. 7939, no. 1, 10 février 2011 (2011-02-10), pages 1-5, XP060010970, DOI: 10.1117/12.876656
- HONDA Y ET AL: "Growth of (1101) GaN on a 7-degree off-oriented (001)Si substrate by selective MOVPE", JOURNAL OF CRYSTAL GROWTH, ELSEVIER, AMSTERDAM, NL, vol. 242, no. 1-2, 1 juillet 2002 (2002-07-01), pages 82-86, XP004366246, ISSN: 0022-0248, DOI: 10.1016/S0022-0248(02)01353-2

**(Cont. page suivante)**

• ZHELEVA T S ET AL: "Pendeo-epitaxy - a new approach for lateral growth of gallium nitride structures", MRS INTERNET JOURNAL OF NITRIDE SEMICONDUCTOR RESEARCH, MATERIALS RESEARCH SOCIETY, WARRENDALE, PA, US, vol. 4S1, no. G3.38, 1 janvier 1999 (1999-01-01), pages L5-L8, XP008107819, ISSN: 1092-5783, DOI: 10.1007/S11664-999-0239-Z

**Description**

DOMAINE DE L'INVENTION

La présente invention concerne, d'une manière générale, des diodes électroluminescentes (LED) et plus spécifiquement des LED comprenant une couche épitaxiale d'au moins un nitrure (N) obtenu avec l'un au moins parmi les matériaux suivants : gallium (Ga), indium (In) et aluminium (Al) et que l'on a fait croître sur un substrat constitué d'un matériau différent.

ARRIERE-PLAN TECHNOLOGIQUE DE L'INVENTION

La production à grande échelle de LED à haute luminosité et à faibles coûts pour des applications commerciales telles que le remplacement des ampoules électriques domestiques est depuis longtemps un sujet qui intéresse tout particulièrement de nombreuses équipes scientifiques et universitaires partout dans le monde.

Une étape majeure a été accomplie au Japon en 1994 par Shuji Nakamura de la Nichia Corporation, qui le premier a réussi à montrer la faisabilité d'une LED bleue à haute luminosité basée sur l'utilisation d'InGaN, c'est-à-dire : le nitrure d'indium gallium, un matériau semiconducteur constitué d'un mélange de nitrure de gallium (GaN) et de nitrure d'indium (InN) qui forme alors un semiconducteur à bande interdite directe de groupe III/groupe V ternaire. Pour l'invention de la LED bleue, Nakamura a partagé le Prix Nobel 2014 de physique avec deux autres scientifiques japonais.

Depuis lors, les composés de nitrure et plus spécifiquement de nitrure de gallium (GaN) et ses alliages avec l'indium (In) et l'aluminium (Al) sont largement employés pour obtenir des dispositifs optoélectroniques capables de fonctionner dans la région des longueurs d'ondes courtes du spectre visible, c'est-à-dire dans la plage du bleu et de l'ultraviolet (UV). Si l'utilisation d'alliages à base de GaN permet également de construire facilement des LED vertes à haute performance, il existe cependant un chute de rendement pour cette plage du spectre connu sous le nom de "chute de rendement dans le vert" ou "green gap" en anglais. Les LED vertes à base de GaN, c'est-à-dire les LED conçues pour fonctionner dans une plage de longueurs d'ondes au-delà de 500 nm (nanomètre = $10^{-9}$ mètre), ne parviennent pas à atteindre une bonne efficacité de conversion du courant électrique en lumière, en particulier lorsqu'on les compare à leurs homologues bleues et ultraviolettes. On a constaté un rendement proche de 80%, pour les LED bleues alors que le chiffre correspondant pour les LED vertes n'est typiquement que d'environ 15%.

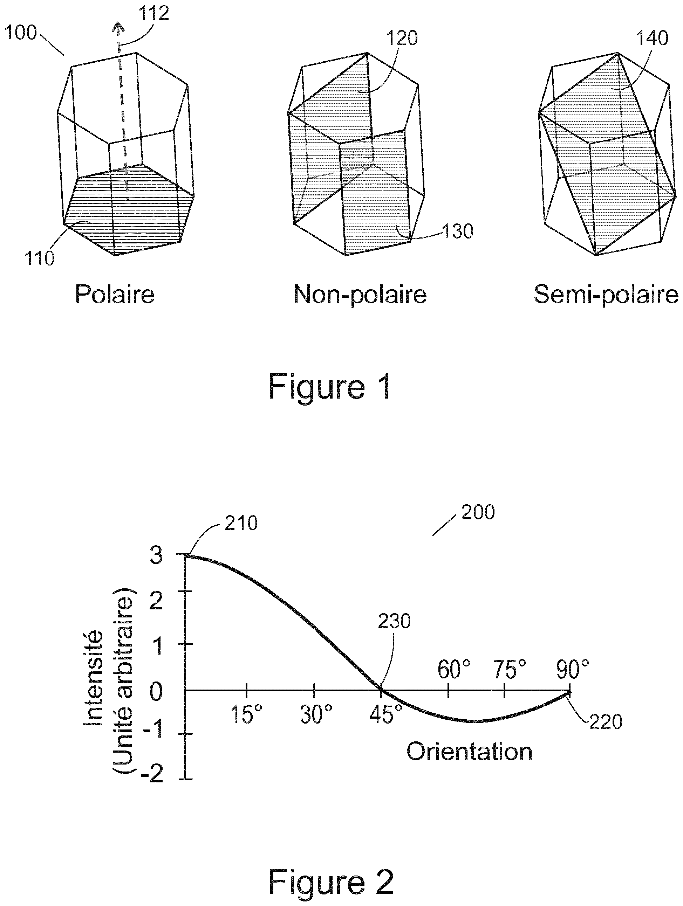

Le faible rendement observé avec les LED vertes s'explique à partir des propriétés cristallographiques des matériaux de composé à base de GaN typiquement soumis à une croissance épitaxiale sur un substrat d'une nature différente en formant ainsi une hétéro-structure à plusieurs couches. La forme cristallographique stable des alliages à base de GaN est la structure de cristal de würtzite représentée sur la **Figure 1.** Dans cette structure hexagonale 100, il convient de définir des plans cristallins tels que : le plan c 110 ; le plan a 120 et le plan m 130. Parce qu'on a découvert qu'il était relativement facile de faire croître une couche épitaxiale de matériau à base de GaN à partir du plan c, c'est-à-dire dans une direction parallèle à l'axe c polaire 112, la plupart des dispositifs à base de GaN expérimentaux et commerciaux ont été construits de cette façon. Cependant, une conséquence négative de cette direction de croissance, c'est-à-dire la direction c 112 pour les LED, est qu'elle provoque un effet Stark à confinement quantique (QCSE) dans la région active du puits quantique en alliage à base d'InGaN du dispositif. Ceci entraine une réduction spectaculaire de l'efficacité de la recombinaison radiative parce que les électrons et les trous sont alors séparés spatialement dans la région active du puits quantique, ce qui réduit la probabilité qu'ils interagissent pour produire de la lumière. La raison de ce comportement est que, en plus de la polarisation spontanée, une polarisation piézoélectrique du cristal se produit en conséquence d'un stress mécanique qui se développe dans cette structure cristalline particulière et qui est connu sous le nom de stress biaxial. Ainsi, les effets liés à la polarisation combinés avec une région active (puits quantiques) et une qualité du matériau réduites sont particulièrement préjudiciables pour les puits quantiques de compositions en indium plus élevées (c'est-à-dire ceux qui sont nécessaires pour les LED vertes). Ces effets sont donc considérés comme les raisons majeures expliquant les pertes d'efficacité des dispositifs optoélectroniques à base de nitrure qui fonctionnent sur des longueurs d'ondes plus élevées (c'est-à-dire le vert).

La **Figure 2** est un diagramme 200 illustrant les effets de l'orientation cristalline sur l'intensité de la polarisation spontanée et piézoélectrique présente dans les puits quantiques d'InGaN. La Figure 2 montre une évolution typique de ce paramètre en fonction de l'orientation par rapport à l'orientation c. L'intensité est en fait maximum 210 pour l'orientation polaire 112, c'est-à-dire comme indiqué ci-dessus, quand la couche épitaxiale à base de GaN croît perpendiculairement au plan c 110. Pour les orientations non-polaires telles que celles du plan a 120 et du plan m 130, l'intensité de la polarisation 220 croise l'axe des zéros. Il convient de noter ici que, pour une orientation semi-polaire, telle que le plan 140 représenté sur la Figure 1, l'effet de la polarisation piézoélectrique peut également être réduit, si on compare avec l'orientation polaire 230.

Une croissance à partir d'un substrat dans un plan différent du plan c classique, par exemple dans un plan semi-polaire tel que 140, n'est pas sans poser aussi des problèmes. En particulier, on a pu observer que les couches à base de GaN que l'on a fait croître sur des substrats plans faits d'un matériau différent présentent typiquement de grandes dislocations et des densités de défaut d'empilement de plan basal si leur croissance a été effectuée à partir d'un plan différent du plan c classique 110.

Par conséquent, pour obtenir des structures semi-polaires planes tout en continuant à faire croître une couche à base de GaN essentiellement dans la direction c afin de réduire au minimum les défauts cristallographiques, plusieurs groupes de R&D ont décrit des procédés basés sur une croissance épitaxiale. Les publications suivantes décrivent de tels exemples de procédés :

--"Fabrication and properties of semi-polar (1-101) and (11-22) InGaN/GaN light emitting diodes on patterned Si substrates" by T. Hikosaka et al. in phys. stat. sol. (c) 5, No. 6, 2234-2237 (2008).
--"Growth of (1 - 0 1) GaN on a 7-degree off-oriented (0 0 1)Si substrate by selective MOVPE"by Honda et al. en J. Cryst. Growth 242 82-6 (2002).

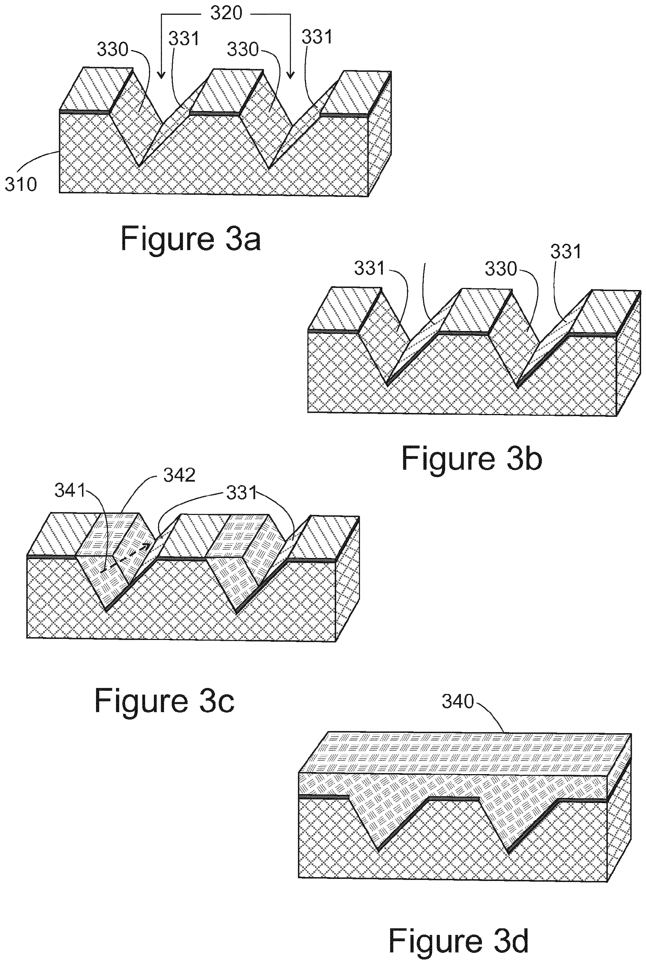

Un exemple donné dans les publications ci-dessus est repris sur la **Figure 3** qui montre, sur la Figure 3a, des tranchées en forme de V 320 qui ont été gravées dans un substrat 310. La largeur et l'espacement des tranchées sont dans une plage de quelques micromètres. Les tranchées sont gravées dans un substrat de silicium 310 qui a une orientation cristalline qui, par exemple, est décalée de 7° par rapport au plan {001} tel que défini par son indice de Miller standard. Ceci permet aux parois latérales des tranchées de former des facettes 330 ayant une orientation correspondant à l'indice de Miller {111} qui est par ailleurs connu comme étant un bon plan de nucléation pour la mise en croissance des couches à base de GaN orientées c. Tel que décrit dans les publications ci-dessus et représenté sur les Figures 3b et 3c, ce procédé permet au dioxyde de silicium (SiO2) ou nitrure de silicium (SiN) ou nitrure de titane (TiN) de couvrir toutes les surfaces à l'exception des facettes orientées {111} 330. Ensuite, l'épitaxie commence à partir de cet ensemble de facettes non masquées, de telle sorte qu'une croissance inclinée d'une couche à base de GaN 342 dans la direction c 341 se produit tout d'abord. La croissance se poursuit latéralement jusqu'à ce que le matériau à base de GaN déborde des tranchées au-dessus de leurs arêtes de manière à finalement entrer en coalescence, comme le montre la Figure 3d, de telle sorte qu'une surface plate 340 est formée qui a une orientation semi-polaire (10-11).

Il convient de noter ici que l'orientation (10-11) est juste un exemple qui ne s'applique qu'avec une croissance s'effectuant sur du Si dont l'orientation est décalée de 7° par rapport au plan {001}. D'autres orientations de GaN semi-polaire requièrent des orientations différentes du silicium. Selon le type de la couche à base de GaN semi-polaire souhaitée, l'orientation du substrat doit être choisie de telle sorte que l'angle entre le plan c de GaN et le plan semi-polaire souhaité soit le même que l'angle entre la facette de cristal de la paroi latérale de la tranchée du substrat et la surface du substrat. Lorsque d'autres orientations sont visées, telles que (20-21) et (11-22), il est nécessaire d'utiliser d'autres substrats de silicium, dans ce cas Si (114) et Si (113) respectivement.

US 2012/276722 A1 (voir particulièrement la figure 1D) décrit la croissance d'une couche de nitrure III semi-polaire par croissance sélective à partir de facettes inclinées de Si (111). US 2012/276722 A1 est considérée comme l'art antérieur le plus proche de l'invention.

US 2012/135557 A1, voir particulièrement les figures 3D et 4A, décrit la croissance de couches de nitrure de groupe III sur un substrat de saphir avec des rainures et des tranchées orthogonales plus profondes que les rainures.

Bien qu'une certaine amélioration des performances des dispositifs à LED vertes ait été anticipée grâce à la technique décrite ci-dessus de croissance de la couche épitaxiale à base de GaN, à partir de la surface supérieure d'un substrat de silicium comportant un rainurage en V. les meilleurs résultats rapportés montrent que les LED vertes n'ont toujours qu'un faible rendement, de l'ordre de 20%, loin des valeurs des LED bleues.

Un objet de l'invention est donc de fournir une solution pour augmenter l'efficacité des LED et en particulier des LED vertes en réduisant le nombre de défauts étendus qui se propagent jusqu'à la surface.

D'autres objets, caractéristiques et avantages de la présente invention apparaitront évidents aux spécialistes de la technique lors de l'examen de la description suivante et en faisant référence aux dessins joints. Il est prévu que tout avantage supplémentaire soit intégré dans celle-ci.

RESUME DE L'INVENTION

Pour atteindre cet objectif, un mode de réalisation de la présente invention concerne un procédé permettant d'obtenir au moins une couche semi-polaire selon la revendication 1.

De préférence les tranchées et les rainures présentent chacune un fond, le fond des tranchées se trouvant à la même profondeur ou en dessous du fond des rainures.

De préférence pendant ladite étape de croissance épitaxiale, ledit matériau ne croît qu'à partir desdites facettes individuelles qui présentent une orientation cristalline {111} et qui forment ladite matrice.

Le procédé de l'invention permet de réduire les superficies disponibles des facettes présentant une orientation cristalline {111} et à partir desquelles le matériau de nitrure comprenant au moins l'un parmi Ga, In et Al peut croître, en permettant une réduction de l'empreinte et ainsi une réduction des défauts étendus pendant la croissance épitaxiale générée à l'interface GaN/AIN/Si ou AIN/Si tout en imposant la croissance dans la direction +c adéquate.

L'invention et le procédé proposé permettent ainsi de réduire la densité des défauts étendus qui se propagent jusqu'à la surface, et par là-même, sur les orientations semi-polaires qui réduisent fortement les effets de la polarisation, on peut obtenir des LED vertes ayant un meilleur rendement.

Par ailleurs, le fait que les facettes présentant une orientation cristalline {111} soient délimitées par des tranchées, donc des reliefs en creux et non pas par un masque formant un relief en saillie, permet de répondre de manière efficace à la problématique consistant à réduire le nombre de défauts dans la couche semi-polaire. En effet, la délimitation des facettes orientées {111} par des tranchées et des rainures permet une croissance et une coalescence des différents germes au moins en partie à distance d'une couche sous-jascente tel que le fond des tranchées et donc en partie au moins au-dessus d'un espace « vide ». En effet la croissance latérale se fait, le long des rainures et au-dessus des tranchées qui ont été gravées.

Cela permet une meilleure relaxation des contraintes lors de la croissance des germes et lors de la coalescence. Les contraintes dans la couche de GaN sont réduites et le nombre de défauts dans la couche semi-polaire 480 est également réduit.

En option, le procédé de l'invention peut en outre avoir au moins l'une quelconque parmi les caractéristiques et étapes optionnelles suivantes prises séparément ou en combinaison :

- Selon un mode de réalisation, le rapport molaire V/III dudit matériau comprenant du nitrure (N) et au moins l'un parmi le gallium (Ga), l'Indium (In) et l'aluminium (Al) est compris entre 100 et 2000. Selon un mode de réalisation, le rapport molaire V/III dudit matériau comprenant du nitrure (N) et au moins l'un parmi le gallium (Ga), l'Indium (In) et l'aluminium (Al) est compris entre 300 et 500 et de préférence entre 380 et 420.

Ce rapport concerne le flux de gaz molaire de chaque précurseur pendant la croissance (pour Ga, TMGa peut être utilisé comme précurseur et, pour N, NH3 peut être utilisé comme précurseur). Ce rapport améliore la direction de la croissance semi-polaire, c'est-à-dire, normale à la surface du substrat, ce qui permet ainsi d'obtenir les cristaux au-dessus des rainures gravées et donc de la surface initiale du substrat.

- Selon un mode de réalisation, l'étape de masquage de la surface supérieure du substrat cristallin, de telle sorte que les facettes opposées auxdites facettes présentant une orientation cristalline {111} soient masquées et que lesdites facettes présentant une orientation cristalline {111} ne soient pas masquées, comprend le dépôt d'une couche de masquage (460) composée d'un matériau comprenant au moins l'un parmi : le dioxyde de silicium (SiO2) et/ou le nitrure de silicium (SiN) et/ou le nitrure de titane (TiN).

- Selon un mode de réalisation, le dépôt d'une couche de masquage est un dépôt angulaire exécuté de telle sorte que l'intégralité de la surface supérieure du substrat cristallin soit masquée, à l'exception desdites facettes qui présentent une orientation cristalline {111}.

- Selon un mode de réalisation, ledit matériau est un matériau à base de nitrure de gallium (GaN). Selon un mode de réalisation, ledit matériau à base de nitrure de gallium (GaN) est composé d'alliages quelconques qui comprennent en outre de l'aluminium (Al) et de l'Indium (In).

- Selon un mode de réalisation, ledit matériau comprenant du nitrure (N) et au moins l'un parmi le gallium (Ga), l'Indium (In) et l'aluminium (Al) est l'un quelconque parmi: le nitrure de gallium (GaN), le nitrure d'indium (InN), le nitrure d'aluminium (AlN), le nitrure d'aluminium gallium (AlGaN), le nitrure d'indium gallium (InGaN), le nitrure d'aluminium gallium indium (AlGaInN), le nitrure d'aluminium indium (AlInN). Dans la description suivante de l'invention, il y est fait généralement référence comme étant un matériau de nitrure comprenant au moins l'un parmi le gallium (Ga), l'Indium (In) et l'aluminium (Al) ou comme les matériaux dits V-N.

- Selon un mode de réalisation, ladite étape de croissance épitaxiale comprend :

  - une première croissance épitaxiale d'un matériau à base de nitrure d'aluminium (AlN) à partir desdites facettes individuelles qui présentent une orientation cristalline {111} et qui forment ladite matrice ;

  - au moins une seconde croissance épitaxiale d'un matériau à base de nitrure de gallium (GaN) à partir dudit matériau à base de nitrure d'aluminium (AlN) ayant subi une croissance épitaxiale.

Ce mode de réalisation est particulièrement avantageux pour éviter la gravure par refusion lorsque le substrat comprend du, ou est constitué de silicium.

- Selon un mode de réalisation, les rainures sont des rainures complètes en forme de V dans lesquelles les deux facettes inclinées opposées se rejoignent au fond de la rainure et définissent ensemble le fond de la rainure. Selon une autre solution, les rainures comprennent un fond plat et les deux facettes opposées se rejoignent au fond de la rainure dans le cas de temps de gravure réduits.

- Selon un mode de réalisation, la longueur desdites facettes présentant une orientation cristalline {111} est supérieure à 50 nm. La longueur d'une facette est mesurée dans la direction inclinée de la facette à partir de la surface supérieure du substrat vers le fond de la rainure.

- Selon un mode de réalisation, la première direction, selon lesquelles les rainures s'étendent principalement correspond à une direction commune au plan de ladite surface supérieure du substrat cristallin et au plan <111>.

- Selon un mode de réalisation, lesdites première et seconde directions forment un angle qui est supérieur à 30°, de préférence supérieur à 40°, de préférence compris entre 40° et 90° et qui est de préférence compris entre 50° et 90° et qui est de préférence compris entre 60° et 90°. Cet angle est le plus petit angle formé par les deux directions. Selon un mode de réalisation, cet angle est supérieur à 50°. Selon un mode de réalisation, cet angle est supérieur à 80°. Selon un mode de réalisation, cet angle est égal à 90°. Cet angle est mesuré dans un plan qui est parallèle à la surface du fond du substrat. Ainsi une deuxième direction ayant subi une rotation par rapport à une première rotation signifie que la deuxième direction est tournée ou inclinée par rapport à la première direction.

- Selon un mode de réalisation, les tranchées sont gravées perpendiculairement aux rainures initiales.

- Selon un mode de réalisation, les tranchées ont une profondeur qui est égale ou supérieure à la profondeur des rainures.

- Selon un mode de réalisation, les tranchées ont des parois latérales verticales. Bien entendu, du fait de l'imprécision inhérente à tout procédé industriel, les parois latérales peuvent ne pas être exactement verticales.

- Selon un mode de réalisation, la pluralité de rainures parallèles présente un pas p1, qui est compris entre 50 nm et 20 $\mu$m, de préférence entre 75 nm et 15 $\mu$m. Ces pas permettent de faciliter le procédé tout en facilitant la coalescence. Le pas p1 des rainures est la largeur d'une rainure plus la distance qui sépare deux rainures consécutives. Le pas p1 est mesuré dans un plan parallèle au fond du substrat.

- Selon un mode de réalisation, la pluralité de tranchées parallèles présentent un pas p2 qui est supérieur à $\dfrac{p1*0.8}{2.5}$ et de préférence supérieur à $\dfrac{p1*0.9}{2.5}$. Selon un mode de réalisation, la pluralité de tranchées parallèles présente un pas p2 qui est inférieur à 1,1*p1 et de préférence inférieur à p1. D'une manière plus générale, p2 est compris entre p1/2,5 +/- 10 % et p1 +/- 10 %. Le pas p2 des tranchées est la largeur d'une tranchée plus la distance qui sépare deux tranchées consécutives. Le pas p2 est mesuré dans un plan parallèle au fond du substrat.

- Selon un mode de réalisation, pendant l'étape de croissance épitaxiale de GaN, la température du substrat est maintenue entre 700 et 1300 °C et de préférence entre 900 et 1100 °C. Ces températures permettent d'améliorer la qualité du cristal.

- Les plages typiques des températures pour la mise en croissance du matériau suivant sont indiquées ci-dessous :

  - AlN : 900 - 1400 °C

  - GaN : 700 - 1300 °C

  - AlN : 900 - 1500 °C

  - InGaN : 400 - 900 °C

  - AlGaN : 900 - 1300 °C

  - AlInN : 600 - 1100 °C

  - AlInGaN : 500 - 1000 °C

- Selon un mode de réalisation, pendant l'étape de la croissance épitaxiale desdits matériaux V-N, la pression est maintenue entre 15 mbar et 1500 mbar et de préférence entre 15 mbar et 700 mbar.

- Selon un mode de réalisation, la pluralité de rainures parallèles présentent un pas p1, la pluralité de tranchées parallèles présentent un pas p2 qui est compris entre 0,9*p1 et 1,1*p1 et le petit angle entre lesdites première et seconde directions est supérieur à 30°, de préférence supérieur à 40°, de préférence supérieur à 60°. Selon un mode de réalisation, cet angle est compris entre 55 et 65°. Ces rapports permettent de faciliter une coalescence simultanée dans toutes les directions.

- Selon un mode de réalisation ladite étape de masquage de la surface supérieure du substrat cristallin de telle sorte que les facettes opposées auxdites facettes présentant une orientation cristalline {111} soient masquées et que lesdites facettes présentant une orientation cristalline {111} ne soient pas masquées est réalisée de manière à former une couche de masquage disposée entre le substrat et ledit matériau et qui couvre l'intégralité de la surface supérieure du substrat à l'exception des facettes individuelles présentant une orientation cristalline {111}.

- Selon un mode de réalisation pendant ladite étape de croissance épitaxiale, ledit matériau croît sous forme de germes dont la coalescence forme ladite couche semi-polaire et dans lequel les dimensions des tranchées et des rainures sont configurées pour permettre une croissance et de préférence une coalescence d'au moins certains des germes, et de préférence tous les germes, sans contact avec, ou tout au moins sans contact avec tout, le fond des tranchées, éventuellement recouverts de la couche de masquage.

- Selon un mode de réalisation pendant ladite étape de croissance épitaxiale, ledit matériau croît sous forme de germes dont la coalescence forme ladite couche semi-polaire et dans lequel les dimensions des tranchées et des rainures sont configurées pour permettre une croissance et de préférence une coalescence des germes avec préservation d'un espace entre au moins certains des, et de préférence tous les germes et le fond des tranchées, éventuellement recouverts de la couche de masquage.

Ces modes de réalisation permettent de résoudre avec encore plus d'efficacité la problématique consistant à réduire le nombre de défauts dans la couche semi-polaire obtenue au final.

- Selon un mode de réalisation, le substrat cristallin est composé de silicium (Si) ou d'un matériau à base de silicium. Selon un mode de réalisation, la croissance de la couche semi-polaire dudit au moins un matériau comprenant du nitrure (N) et au moins l'un parmi le gallium (Ga), l'Indium (In) et l'aluminium (Al) est, par conséquent, une croissance en trois dimensions (3D) qui se produit à partir de la matrice de facettes individuelles présentant une orientation cristalline {111}.
- Selon un mode de réalisation, la surface structurée supérieure initiale est formée d'un ensemble de rainures parallèles comprenant au moins un bord incliné avec une orientation cristalline {111}.

Selon un autre mode de réalisation, l'invention concerne un procédé de fabrication d'au moins une diode électroluminescente (LED) configurée pour émettre dans la gamme de vert des longueurs d'ondes, comprenant le procédé permettant d'obtenir une couche semi-polaire d'au moins un matériau comprenant du nitrure (N) et au moins l'un parmi le gallium (Ga), l'Indium (In) et l'aluminium (Al) sur une surface supérieure d'un substrat cristallin, selon le procédé mentionné ci-dessus.

Selon un autre mode de réalisation, l'invention concerne un dispositif microélectronique selon la revendication 28.

En option, le dispositif microélectronique de l'invention peut, en outre, avoir au moins l'une quelconque parmi les caractéristiques optionnelles suivantes, prises séparément ou en combinaison :

- Selon un mode de réalisation optionnel, ledit matériau est en contact direct avec les facettes individuelles présentant une orientation cristalline {111}.
- Selon un mode de réalisation optionnel, les tranchées et les rainures présentant chacune un fond, le fond des tranchées se trouvant à la même profondeur ou plus profond que le fond des rainures ;
- Selon un mode de réalisation optionnel, le dispositif comprend également une couche de masquage qui est disposée entre le substrat et ledit matériau, la couche de masquage couvrant l'intégralité de la surface supérieure du substrat, à l'exception des facettes individuelles présentant une orientation cristalline {111}.
- Selon un mode de réalisation optionnel, la pluralité de rainures parallèles présente un pas p1, la pluralité de tranchées parallèles présente un pas p2 qui est compris entre 0,8*p1 et 1,2*p1 et le petit angle défini par lesdites première et seconde directions est supérieur à 30°. Selon un mode de réalisation, cet angle est supérieur à 40° et est, de préférence, supérieur à 60°. Selon un mode de réalisation, cet angle est supérieur à 55°.

Selon un autre mode de réalisation, l'invention concerne les diodes électroluminescentes (LED) comprenant un dispositif microélectronique selon l'invention.

Selon un autre mode de réalisation, l'invention concerne un procédé de croissance d'une couche semi-polaire de matériau de nitrure comprenant au moins l'un parmi le gallium (Ga), l'Indium (In) et l'aluminium (Al) sur une surface structurée supérieure d'un substrat cristallin, ladite surface structurée supérieure étant agencée de manière à comprendre un ensemble de facettes en stries parallèles inclinées présentant une orientation cristalline {111}, ledit procédé comprenant en outre les étapes consistant à :

- effectuer une nouvelle structuration de la surface supérieure par gravure d'un ensemble de tranchées inclinées par rapport aux facettes en stries, en brisant l'ensemble de facettes en stries en une matrice de facettes individuelles orientées {111} ;

- mettre en croissance la couche dudit matériau à partir de la matrice de facettes individuelles orientées {111}.

Avant la mise en croissance de la couche semi-polaire dudit matériau, toutes les surfaces de la surface structurée supérieure, sauf les facettes orientées {111}, sont protégées par une couche déposée d'un matériau comprenant de l'oxyde de silicium (SiO2) et/ou du nitrure de silicium (SiN) et/ou du nitrure de titane (TiN).

Un avantage de l'invention est que les surfaces d'ensemencement, c'est-à-dire les facettes orientées {111}, utilisées pour mettre en croissance la couche épitaxiale de matériau à base de nitrure voient leurs superficies réduites du fait que les tranchées ont été gravées en premier.

L'avantage de l'invention est la réduction des défauts générés comme conséquence de la réduction de l'empreinte du matériau V-N sur le substrat.

Ceci permet une réduction de la quantité de défauts dans le cristal de croissance dans la couche épitaxiale en permettant ainsi d'obtenir des LED vertes (jaunes/rouges/ultraviolettes) ayant un meilleur rendement.

Selon un autre mode de réalisation, l'invention concerne un procédé permettant d'obtenir une couche semi-polaire d'au moins un matériau comprenant du nitrure (N) et au moins l'un parmi le gallium (Ga), l'Indium (In) et l'aluminium (Al) sur une surface supérieure d'un substrat cristallin, ledit procédé comprenant les étapes suivantes :

Obtenir sur la surface supérieure du substrat cristallin une pluralité de rainures parallèles qui s'étendent dans une première direction, chaque rainure comprenant au moins deux facettes inclinées opposées formant chacune une strie continue qui s'étend dans ladite première direction, l'une desdites deux facettes opposées présentant une orientation cristalline {111} ;

Graver une pluralité de tranchées parallèles qui s'étendent dans une seconde direction qui a subi une rotation par rapport à ladite première direction de la rainures, la pluralité de tranchées parallèles qui définissent ainsi avec les rainures une pluralité de facettes discontinues présentant une orientation cristalline {111} ;

Masquer la surface supérieure du substrat cristallin, de telle sorte que les facettes opposées auxdites facettes présentant une orientation cristalline {111} soient masquées et que lesdites facettes présentant une orientation cristalline {111} ne soient pas masquées ;

Croissance épitaxiale dudit matériau de base à partir desdites facettes présentant une orientation cristalline {111}.

BREVE DESCRIPTION DES DESSINS

La FIGURE 1 illustre différentes orientations cristallines dans une structure de cristal de würtzite.

La FIGURE 2 montre l'intensité de la polarisation piézoélectrique dans une structure de cristal de würtzite en fonction de l'orientation.

La FIGURE 3 montre la croissance d'une couche épitaxiale à partir d'un seul ensemble de facettes orientées {111} comme décrit dans l'art antérieur.

La FIGURE 4, constituée des figures 4a à 4h, illustre les étapes d'un procédé selon un mode de réalisation de l'invention qui permet une réduction de la densité des défauts de la couche épitaxiale après croissance.

La FIGURE 5, constituée des figures 5a et 5b, sont deux vues en coupe des structures illustrées en figures 4g et 4h selon des coupes passant par les facettes orientées {111}, perpendiculaires aux facettes orientées {111} et perpendiculaires aux tranchées parallèles.

Les figures sont données à titre d'exemples et ne sont pas limitatives de l'invention. Elles sont des représentations schématiques de principe destinées à faciliter la compréhension de l'invention et ne sont donc pas nécessairement à la même échelle que les applications pratiques. En particulier, les épaisseurs relatives des différentes couches et films ne sont pas représentatifs de la réalité.

DESCRIPTION DETAILLEE

La description détaillée suivante de l'invention fait référence aux dessins joints. Alors que la description comprend des modes de réalisation donnés à titre d'exemples, d'autres modes de réalisation sont possibles, et des modifications peuvent être apportées aux modes de réalisation décrits, sans qu'on s'éloigne de l'esprit et du champ d'application de l'invention.

Selon un mode de réalisation, le procédé de l'invention crée une matrice de structures à facettes semblables à des piliers à partir desquelles une croissance semi-polaire multidimensionnelle d'au moins un nitrure (N) obtenu avec l'un au moins parmi les matériaux suivants :gallium (Ga), l'Indium (In) et l'aluminium (Al) est ensuite réalisée. La matrice de structures à facettes semblables à des piliers est obtenue en formant des rainures, typiquement des rainures en V, et des tranchées qui sont perpendiculaires ou inclinées par rapport aux rainures.

Le procédé de l'invention réduit donc l'empreinte de la couche épitaxiale en réduisant le contact de surface avec le substrat de manière à encore réduire la densité de défauts étendus générés pendant la nucléation. Cette amélioration du matériau des couches de matériau V-N orientées semi-polaires permet une nouvelle réduction de la perte d'efficacité, c'est-à-dire, de la perte d'efficacité lors de la conversion d'un courant électrique en lumière.

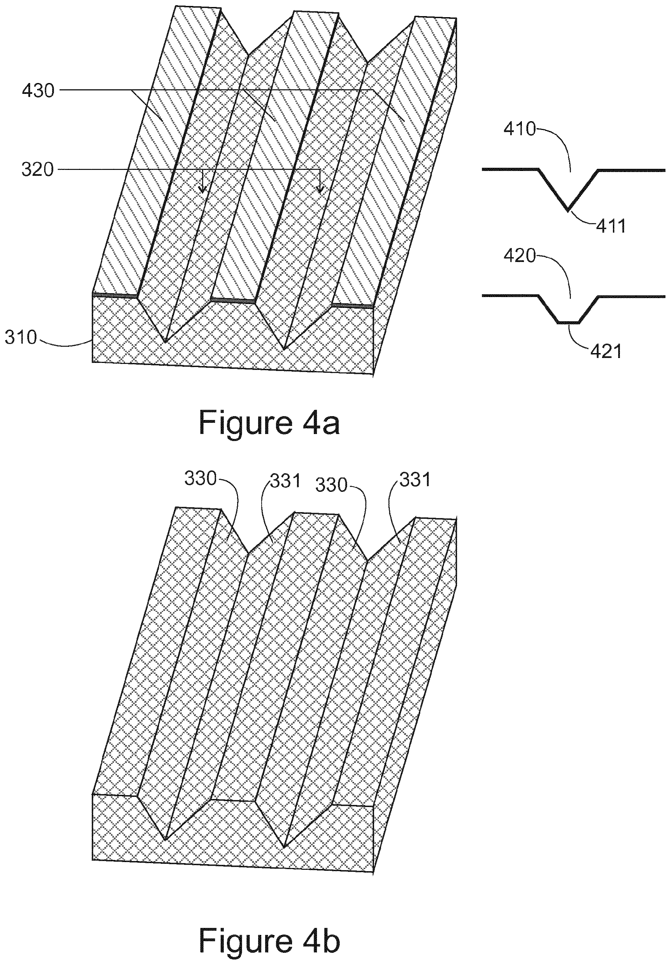

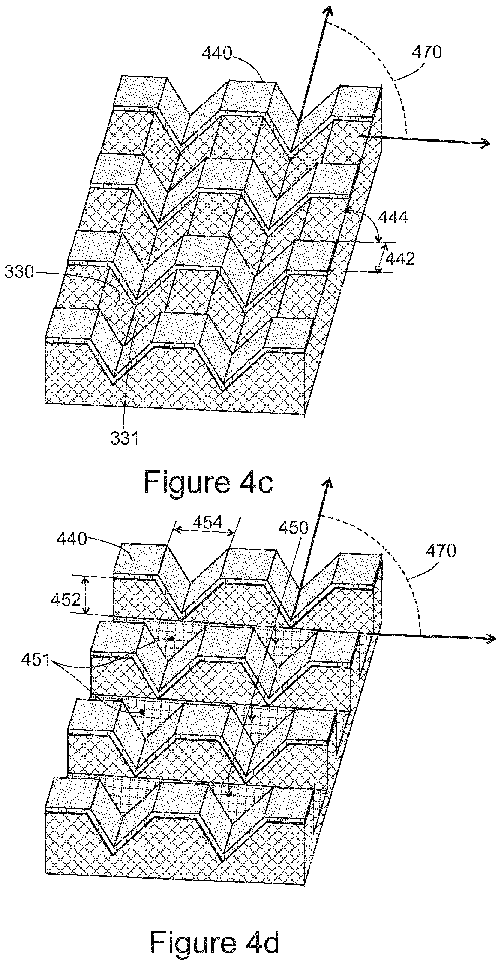

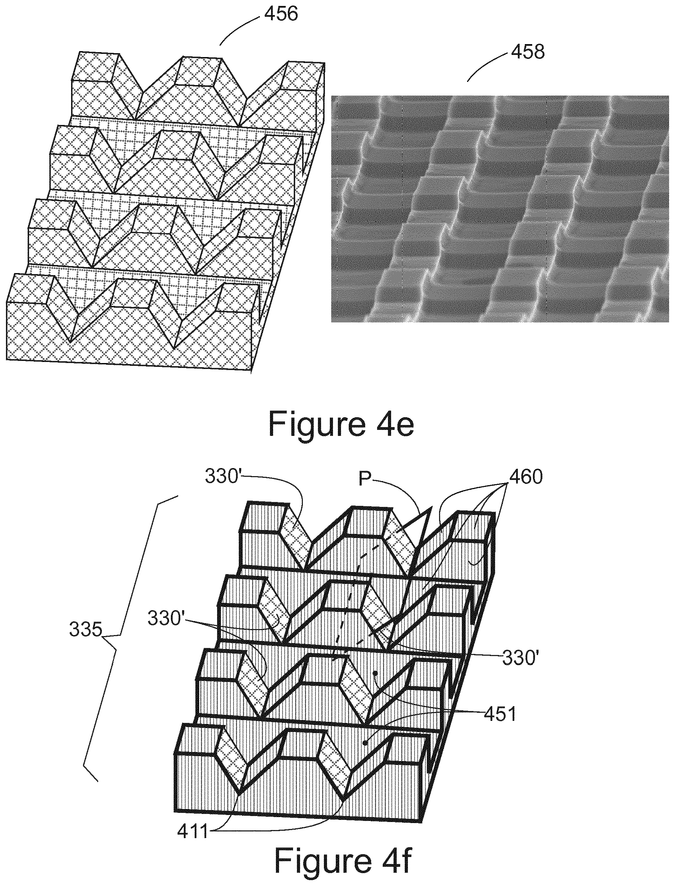

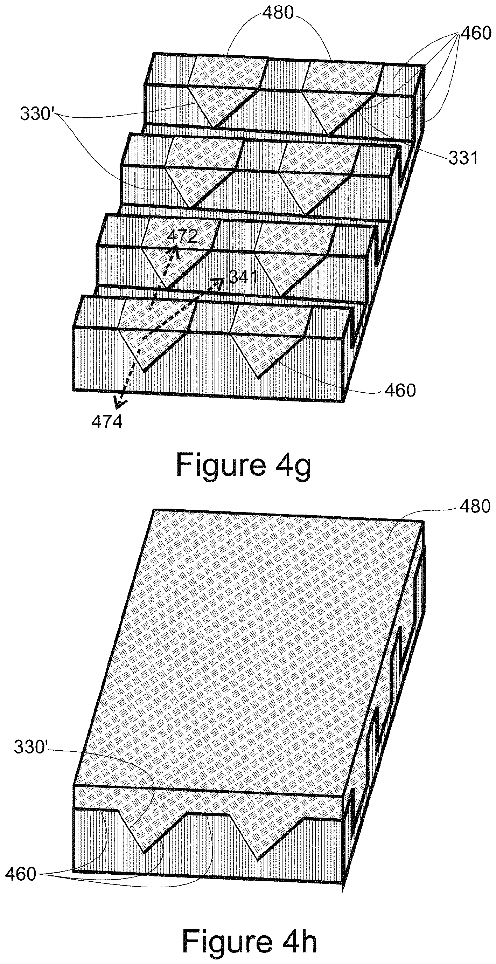

Un mode de réalisation détaillé est décrit ci-dessous en faisant référence à la **Figure 4** qui est constituée des Figures 4a à 4h.

La fabrication commence avec la formation de rainures 320. Ces rainures peuvent être des rainures en V, telles que celles qui ont été précédemment traitées sur la Figure 3. Elles sont gravées dans un substrat, de préférence composé de silicium

Comme mentionné ci-dessus et illustré à nouveau sur les Figures 4a et 4b, la création de rainures en V 320 est par exemple réalisée à partir de la surface d'une couche cristalline 310, par exemple un substrat de silicium (Si) présentant une orientation cristalline décalée de 7° par rapport au plan {001}. Pour les substrats de Si, d'autres orientations sont possibles, par exemple décalée de 1° par rapport au plan {114} et au plan {113}. La présente invention n'est pas limitée à l'une quelconque parmi ces orientations. Par exemple, l'invention s'applique également au substrat de silicium (Si) 310 ayant une orientation cristalline décalée de 6° ou 8° par rapport au plan {001}.

La gravure des rainures en V est réalisée à l'aide de techniques anisotropes standard bien connues qui sont basées sur l'utilisation d'agents de gravure humide tels que l'hydroxyde de tetraméthylammonium (TMAH) ou l'hydroxyde de potassium (KOH). Ce type de gravure anisotrope permet que des facettes orientées {111} 330 soient gravées dans le substrat 310.

La gravure peut créer des rainures en V 410 complètes, telles que celles décrites sur les figures 3 et 4. Dans une rainure en V complète, les deux surfaces ou facettes inclinées opposées 330, 331 se rejoignent pour former le fond 411 de la rainure 410. Par conséquent, dans une rainure en V, le fond 411 de la rainure est en forme de V.

Selon un autre mode de réalisation de l'invention, la gravure de la rainure en V peut créer des rainures en V 420 incomplètes. Dans une rainure en V incomplète, les deux surfaces inclinées opposées se rejoignent au fond 421 de la rainure, le fond 421 formant une surface à peu près plate. Des rainures en V 420 incomplètes sont obtenues grâce à des temps de gravure plus courts que pour les rainures en V 410 complètes.

La couche cristalline 310 présente une face externe également désignée surface supérieure. Les rainures parallèles 320, 410, 420 sont orientées selon une direction qui correspond à une direction commune au plan de la face externe de la couche cristalline 310 et au plan <111> que l'on veut révéler par attaque chimique. Cette direction est une direction de type <110>. Ainsi les rainures 320, 410, 420 sont parallèles à l'intersection entre le plan de la surface supérieure de la couche cristalline 310 et le plan <111>. Dans l'exemple de mise en œuvre de l'invention illustré par les figures 4a-4h, il s'agit d'une direction du type <110>.

L'exemple non limitatif suivant suppose l'utilisation d'un substrat de Si avec une orientation cristalline décalée de 7° par rapport au plan {001}. Les rainures en V sont gravées après qu'un masque dur 430 a été découpé dans une couche de dioxyde de silicium (SiO2) ou de nitrure de silicium (SiN) ou de nitrure de titane (TiN) mise en croissance ou déposée sur le dessus du substrat à l'aide des techniques lithographiques standard. Les spécialistes de la technique sauront comment choisir la technique la mieux adaptée. Par example, si des dimensions submicroniques doivent être utilisées, des techniques de lithographie par faisceau électronique ou par nano-impression peuvent être utilisées.

Comme le montre la Figure 4b, le masque de SiO2 est enlevé ultérieurement, par exemple en utilisant un agent de gravure humide, tel qu'une solution de gravure d'oxyde tamponnée (BOE) qui est par exemple un mélange dilué de fluorure d'ammonium (NH4F) ou d'acide fluorhydrique (HF).

Les rainures peuvent être gravées dans les limites d'une plage de largeurs qui peut aller de 100 nm et peut atteindre 15 $\mu$m ($10^{-6}$ mètre). Des dimensions plus petites, de l'ordre des centièmes de nanomètres ($10^{-9}$ mètre), peuvent éventuellement nécessiter l'utilisation de techniques de lithographie par nano-impression ou par faisceau électronique. Graver des facettes plus grandes 330 signifie que l'empreinte est plus grande, auquel cas plus de défauts sont par conséquent créés. Le contraire se vérifie pour des facettes plus petites. En ce qui concerne la période de répétition des rainures, plus elle est grande, meilleur est le taux de dislocations car il tend à diminuer pendant les premières phases de la croissance, et toute nouvelle extension des cristaux conduit à l'obtention d'un matériau exempt de défauts. Il peut s'avérer nécessaire de décider d'un compromis, en fonction des applications. Dans tous les cas, on peut affirmer que des durées plus courtes avec des facettes 330 plus grandes créent finalement plus de défauts.

Les largeurs plus importantes, dans la plage des $\mu$m, risquent de poser d'autres problèmes tels que l'obtention d'une bonne coalescence des extrémités de croissance en particulier sur le silicium où des problèmes potentiels de gravure par refusion risquent également de se poser. En fait, la gravure par refusion est une réaction chimique qui se produit entre le gallium et le silicium, ce qui entraine une diffusion intense de silicium à des températures typiques de croissance MOCVD qui risquent d'endommager de grandes zones sur la tranche, et, par conséquent, de faire obstacle à toute fabrication ultérieure de dispositif. De manière avantageuse, pour éviter ce phénomène, avant croissance du nitrure de gallium (GaN), le procédé comprend la croissance d'une première couche de nitrure d'aluminium (AlN) sur le substrat à base de silicium, de préférence constitué de silicium.

Plus généralement, l'étape où l'on fait croître la au moins une couche (480) composée d'au moins un matériau comprenant du nitrure (N) et avec l'un au moins des matériaux choisi parmi le gallium (Ga), l'Indium (In) et l'aluminium (Al) peut comprendre plusieurs étapes de croissance, chaque étape comprenant la croissance d'un matériau comprenant du nitrure (N) avec l'un au moins des matériaux parmi le gallium (Ga), l'Indium (In) et l'aluminium (Al).

Par exemple, pour faire croître une couche de GaN ou d'InGaN, le procédé comprend une première étape de croissance d'AlN directement à partir des facettes individuelles à base de silicium qui présentent une orientation cristalline {111}. Ensuite, on fait croître le GaN ou InGaN à partir de l'AlN.

De préférence, pour faire croître une couche d'AlInGaN ou d'InN, le procédé comprend :

- une première étape de croissance d'AlN directement à partir des facettes individuelles à base de silicium qui présentent une orientation cristalline {111} ;

- une deuxième étape de croissance de GaN à partir de cette croissance d'AlN.

- une troisième étape de croissance d'AlInGaN ou d'InN à partir de GaN.

De préférence, pour faire croître une couche d'InAlN, le procédé peut comprendre :

- une première étape croissance d'AlN directement à partir des facettes individuelles à base de silicium qui présentent une orientation cristalline {111} ;

- une deuxième étape de croissance de GaN à partir de cette croissance d'AlN.

- une troisième étape de croissance d'InAlN à partir de GaN.

De préférence, pour faire croître une couche d'AlGaN, le procédé peut comprendre :

- une première étape de croissance d'AlN directement à partir des facettes individuelles à base de silicium qui présentent une orientation cristalline {111} ;

- une seconde étape de croissance d'AlGaN à partir de cette croissance d'AlN.

Selon une autre solution, plus spécifiquement, dans le cas où le rapport de Ga est suffisamment faible, on fait croître directement l'AlGaN à partir des facettes individuelles à base de silicium qui présentent une orientation cristalline {111}.

En option, la taille des facettes {111} 330 peut varier en fonction du temps de gravure. Il n'est pas obligatoire d'avoir des rainures en V complètes ; avoir des rainures incomplètes 420 est possible, auquel cas des rainures à facettes plus petites sont obtenues.

De manière avantageuse, puisque les rainures à facettes sont plus petites, une moindre densité de dislocation est obtenue.

Une couche de masquage est alors formée qui se présente sous la forme de longues bandes.

Par exemple, ce masque est obtenu à partir d'une couche de résine telle qu'une résine photosensible déposée sur le substrat 310 comprenant les rainures 410, 420.

Un second niveau de lithographie est alors réalisé en permettant que les longues bandes de résine soient insolées. Ce masque du second niveau est éventuellement le même que celui qui est utilisé pour créer les rainures en V et qui est utilisé avec une rotation différente. Le résultat de cette étape est décrit sur la Figure 4c, qui montre les stries restantes 440, après que la résine a été développée.

Tout type de masque peut être utilisé et l'invention n'est pas limitée à un quelconque matériau de masquage.

En option, les stries peuvent être réalisées suivant des angles 470 différents de l'angle de 90°.

Par exemple, le petit angle 470 entre la direction principale des rainures 410, 420 et la direction principale des stries est supérieur à 30° et est, de préférence, compris entre 40° et 90°. Selon un mode de réalisation, cet angle est compris entre 50° et 90°. Selon un mode de réalisation, cet angle est compris entre 55° et 65°. Cet angle 470 est mesuré dans un plan qui est parallèle au fond du substrat formé par la couche cristalline 310, c'est-à-dire dans un plan horizontal selon les figures 4a à 4h. Cet angle est décrit sur les figures 4c et 4d. Ainsi cet angle est défini entre la direction d'orientation des bandes 440 et la direction commune au plan de la face externe de la couche cristalline 410 et au plan <111>, cette direction commune étant, comme indiqué précédemment, la direction d'orientation des rainures 32, 410, 420.

La largeur 442 des bandes peut également varier entre une limite inférieure de 100 nm et une limite supérieure de 15 $\mu$m

Avec les bandes 440 de résine laissées en place, les zones de silicium non masquées sont gravées à l'aide de l'une quelconque des nombreuses techniques de gravure du silicium utilisées par l'industrie de la microélectronique. Ceci crée des tranchées 450 telles que décrites sur la figure 4d.

Par conséquent, les facettes orientées {111} continues 330 précédemment définies par les rainures 410, 420 sont maintenant interrompues et définissent chacune un alignement de facettes individuelles 330' séparées les unes des autres par une tranchée 450.

La Figure 4e montre des tranchées et des rainures en V dans un substrat tout silicium après gravure à travers le masque de bandes et après enlèvement du masque. La référence 456 est un dessin du résultat après gravure, alors que 458 est une image réelle montrant des rainures en V 420 incomplètes séparées par des tranchées 450 avec un fond 451 non plat dans ce cas. Dans la pratique, la surface du fond 451 des tranchées découpées 450 reproduit le dessus des surfaces des rainures en V. Il faut remarquer ici que, bien que des facettes orientées {111} 330 soient reproduites au niveau du fond 451 des tranchées 450, elles sont cependant très déformées du fait de la gravure et du bombardement ionique et elles ne sont donc plus compatibles pour une bonne croissance cristalline.

La profondeur des tranchées découpées 452 doit, au minimum, correspondre au fond 411, 421 de la rainure en V 320. Ce dernier paramètre dépend de la largeur 454 de l'ouverture du premier masque. Par exemple, si l'ouverture du masque a une largeur de 5 $\mu$m, la profondeur de la rainure en V créée approche les 5 $\mu$m, ce qui nécessite alors des tranchées 450 de 5 $\mu$m de profondeur. Cependant, ceci n'est qu'un exemple d'une orientation particulière. Les tailles peuvent varier selon les angles des facettes. Par exemple, dans Si (114) les facettes {111} 330 sont à 74° et 35°, ce qui modifie leur taille en fonction de la profondeur.

D'une manière plus générale, les tranchées découpées 452 sont aussi profondes, voire plus profondes que le fond 411, 421 de la rainure en V.

La profondeur des tranchées 450 et des rainures 320 est mesurée suivant une direction qui est perpendiculaire au fond du substrat 310. Sur les dessins décrits, la profondeur des tranchées 450 et des rainures 320 est mesurée suivant la direction verticale.

Des gravures moins profondes sont également acceptables, puisque la croissance est sélective. Ainsi, une profondeur dans une plage comprise entre 100 nm et 50 $\mu$m fonctionne. Le fait que le fond de la rainure gravée soit plat n'est pas un point crucial parce qu'il sera finalement couvert par le SiO2 et qu'aucune croissance ne se produira sur celui-ci.

La Figure 4f montre le résultat de l'étape suivante, au cours de laquelle une couche de masquage 460, par exemple une couche diélectrique à base ou composée d'oxyde de silicium (SiO2) ou de nitrure de silicium (SiN) est déposée sur toutes les surfaces à l'exception des facettes individuelles orientées {111} 330'. Cette étape est accomplie avec l'aide d'un équipement standard connu sous le nom de pulvérisateur par rayonnement ionique ("ion beam sputter" ou IBS) dans lequel l'angle de dépôt peut être ajusté de manière, dans ce cas, à empêcher le dépôt de se produire sur les facettes orientées {111} 330. Par conséquent, les facettes individuelles 330' forment ensemble une matrice 335 de facettes 330' individuelles ayant une orientation {111} et étant séparées les unes des autres. En particulier la couche de masquage 460 recouvre les facettes opposées aux facettes orientées {111} comme cela apparaît en figure 4f par exemple.

La Figure 4g montre comment la croissance d'un nitrure obtenu avec l'un au moins parmi les matériaux suivants Ga, In et Al (matériau V-N) 480 commence à partir des facettes individuelles {111} 330' qui ne sont pas couvertes par la couche de masquage diélectrique 460. Comme illustré sur les figures 4g et 4f cette couche de masquage 460 est située entre le substrat 310 et la couche 480. La flèche 341 indique, comme précédemment, la direction de la croissance dans le plan c, alors que les flèches 472 et 474 indiquent comment, dans la structure de l'invention, la croissance s'étend également latéralement pour remplir les tranchées. Il convient de noter que la Figure 4g n'a, de toute évidence, pour but que de montrer les directions de la croissance et ne constitue pas une représentation exacte de la réalité. En pratique, la croissance épitaxiale permet une coalescence latérale et une coalescence également sur les stries, c'est-à-dire une croissance selon chacune des directions 341, 472, 474.

La croissance a principalement lieu selon la direction 341.

Par conséquent, la croissance a lieu uniquement à partir desdites facettes individuelles 330' qui présentent une orientation cristalline {111}.

Avec un temps de croissance plus long et dans des conditions de croissance optimisée, le cristal sort de la rainure au-dessus de la surface du substrat. Ceci peut être obtenu essentiellement avec un faible rapport V-III.

Enfin, comme le montre la Figure 4h, la coalescence de tous les cristaux est obtenue pendant que la croissance du matériau épitaxial continue jusqu'à ce que la surface finale située le plus haut forme une couche semi-polaire continue 480 à base de V-N.

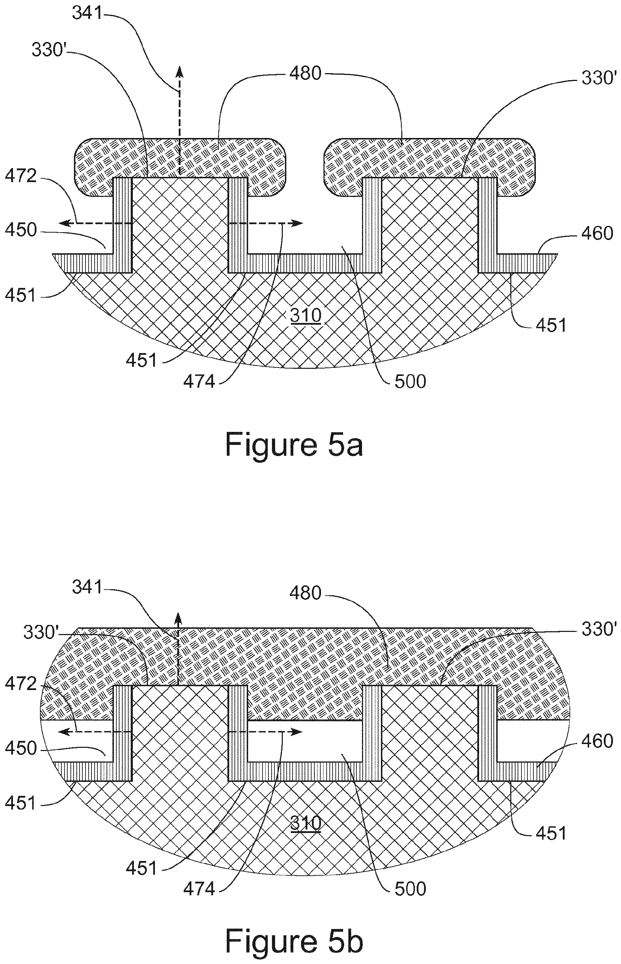

Les figures 5a et 5b, sont deux vues en coupe des structures illustrées en figures 4g et 4h selon des coupes passant par les facettes orientées {111}, perpendiculaires aux facettes orientées {111} et perpendiculaires aux tranchées parallèles. Le plan de cette coupe est référencé P en figure 4f.

Sur ces figures, apparaissent ainsi les facettes 330' orientées {111} à partir desquelles les germes 480 croissent. Contrairement à la figure 4g qui est très simplifiée, la figure 5a fait apparaître une croissance latérale des germes 480, c'est-à-dire une croissance à l'intérieur des tranchées 450, selon les directions 472 et 474 mentionnées ci-dessus. Les directions de croissance 341, 472 et 474 sont reprises sur ces figures 5a et 5b. La croissance latérale se fait ainsi le long des rainures et au-dessus des tranchées gravées. Ce type d'épitaxie peut être qualifié de pendeo epitaxy.

Ces facettes 330' orientées {111} sont situées au-dessus du fond des tranchées 541, de préférence recouvert par la couche de masquage 460. On qualifiera de fond 451 des tranchées 450 le fond formé par le relief en creux de la tranchée 450, que ce fond soit ou non recouvert d'une ou plusieurs couches, telle qu'une couche de masquage 460. Ce fond peut être plat ou non.

Comme illustré en figure 5a, les germes 480 se développent, avant coalescence, « au-dessus du vide » c'est-à-dire qu'ils se développent à distance du fond 451 des tranchées 450. Un espace 500 vide, c'est-à-dire sans matières solide est donc présent entre les germes 480 en cours de croissance et le substrat 310 recouvert par la couche de masquage 460.

Par conséquent, durant au moins une partie de leur croissance, les germes 480 se développent sans subir de contraintes provenant d'un contact avec le fond 451 des tranchées 450. Cela permet de réduire les défauts dans les germes 480, pendant au moins partie de leur croissance. Les défauts dans la couche semi-polaire 480 obtenue au final sont donc réduits.

Comme illustré en figure 5b, selon un mode de réalisation non limitatif mais particulièrement avantageux, la coalescence des germes 480 s'effectue alors que ces derniers ne sont pas en contact avec le fond 451 des tranchées 450 ou alors que ces derniers ne sont pas entièrement en contact avec le fond 451 des tranchées 450.

De préférence, les dimensions en largeur (selon les directions 472 et 474) et en profondeur (selon l'épaisseur du substrat 310) des tranchées 450 et des rainures 320 sont configurées pour permettre une coalescence des germes 480 sans que certains au moins des germes soient entièrement au contact du fond 451 des tranchées 450. Naturellement l'épaisseur de la couche de masquage 460 est également dimensionnée de manière à ne pas entrer au contact des germes 480 en cours de croissance.

Selon un mode de réalisation avantageux, au moins certains des et de préférence tous les germes 480 sont entièrement à distance du fond 451 des tranchées 450. Ainsi ces germes ne sont pas au contact du fond 451 des tranchées 450 ou des éventuelles couches telles que la couche de masquage 460 qui recouvrent le fond des tranchées.

La figure 5b illustre ainsi un mode de réalisation dans lequel l'espace 500 est présent entre la couche semi-polaire 480 et le fond des tranchées 450 éventuellement recouvert de la couche de masquage 460, après coalescence des différents germes.

De préférence, l'espace 500 est présent entre la couche semi-polaire finale et le fond des tranchées 450.

Ces modes de réalisation procurent plusieurs effets techniques très avantageux.

La coalescence des différents germes au-dessus d'une tranchée 450, donc au au-dessus d'un espace 500 « vide » permet une meilleure relaxation des contraintes lors de la coalescence et réduit les contraintes dans la couche de GaN.

Il en résulte une couche épitaxiée sans gradient de contrainte dans les zones en recroissance latérale.

A titre de comparaison, les structures du type "ELO" acronyme du vocable anglais « epitaxial latéral overgrowth » (épitaxie par recroissance latérale) induisent des courbures des facettes supérieures et latérales qui se traduisent par des problèmes lors de la coalescence (génération de dislocations et possible cavités).

Au final l'invention permet de réduire significativement le nombre de défauts dans la couche semi-polaire 480.

Par ailleurs, la présence de cet espace 500, sur au moins une portion du fond 451 des tranchées permet de faciliter la délamination de la couche semi-polaire du fait de l'interface plus fragile entre cette dernière et le substrat. Ainsi, l'invention permet une diminution du risque de rupture de la couche de GaN lors de la délamination.

On notera que ces effets techniques et avantages se manifestent même si une partie de la couche semi-polaire 480 est en contact du fond 451 des tranchées 450.

Un exemple non limitatif d'un procédé de fabrication selon l'invention est décrit ci-dessous. Les étapes principales de ce procédé ont été décrites ci-dessus en faisant référence aux Figures 4a à 4h :

Étape 1 : Dépôt sur un substrat 310 propre d'une couche protectrice 430 constituée, par exemple, de SiO2. Une épaisseur de la couche déposée d'environ 10 nm est suffisante, mais peut être adaptée. Du SiN ou du TiN peuvent également être utilisés à la place du SiO2

Étape 2 : Lithographie avec un premier masque découpé en stries et développement de la résine.

Étape 3 : Alors que la résine se trouve toujours sur le dessus, la couche de protection exposée (SiO2 ou SiN ou TiN) est, par exemple, gravée dans un plasma de trifluorométhane en présence d'oxygène (plasma CHF3/O2). D'autres agents de gravure peuvent également être utilisés. Cette étape vise à créer une ouverture pour la gravure humide anisotrope ultérieure avec KOH ou TMAH. Selon une autre solution, un agent de gravure d'oxyde tamponné (BOE) peut être utilisé pour enlever le masque.

Étape 4 : La résine est retirée à l'aide d'un plasma d'acétone et d'oxygène.

Étape 5 : La gravure au KOH ou au TMAH commence à créer les facettes {111} 330 souhaitées qui forment des rainures en V complètes ou incomplètes 320 comme le montre la Figure 4a.

Étape 6 : Les substrats rainurés sont nettoyés avec du chlorure d'hydrogène (HCl) pour enlever les résidus cristallins de KOH de la surface.

Étape 7 : Le masque de protection en SiO2 ou en SiN ou en TiN est enlevé à l'aide d'une solution de gravure tamponnée BOE ce qui permet ainsi d'obtenir un substrat découpé tout en silicium comme le montre la Figure 4b.

Étape 8 : Lithographie avec un second masque en stries. Les masques peuvent éventuellement être les mêmes que le premier masque et utilisés avec une orientation différente. Selon la profondeur de la rainure en V, la lithographie doit être adaptée en conséquence. Par exemple, une rainure en V de 5 μm de profondeur nécessite une énergie d'exposition de 200 milliJoules et, enfin, des délais de développement plus longs. Une rainure moins profonde, par exemple : de 1 μm de profondeur, nécessite moins d'énergie d'exposition, de l'ordre de 120 milliJoules. Les figures mentionnées ci-dessus dépendent également du type de résine utilisée et de l'épaisseur qui en résulte.

La résine est alors développée (Figure 4c).

Étape 9 : A partir de la résine formant des motifs et utilisée comme masque, une gravure anisotrope du silicium est effectuée dans un plasma couplé par induction (ICP) d'hexafluorure de soufre (SF6) (ou autres agents de gravure) pour former des tranchées 450 ayant des parois latérales droites (Figure 4d).

Étape 10 : La résine est retirée à l'aide de plasma d'acétone et d'oxygène.

Étape 11 : Un dépôt angulaire de SiO2 ou SiN ou TiN est réalisé sur toutes les surfaces à l'exception des facettes {111} pour forcer la croissance de la couche épitaxiale dans une seule direction c.

Étape 12 : On procède à une croissance épitaxiale d'une couche de nitrure obtenu avec l'un au moins parmi les matériaux suivants : gallium (Ga), indium (In) et aluminium (Al) à partir des facettes non masquées {111}. En fonction de la nature dudit nitrure obtenu avec l'un au moins des matériaux suivants : gallium (Ga), indium (In) et aluminium (Al), une première couche, typiquement d'AlN, est mise en croissance en premier sur les facettes 330'.

Pendant toutes les étapes précédentes, les enduits protecteurs qui forment les masques peuvent être remplacés par tout type d'autre matériau de masquage.

Les vitesses de croissance suivantes ont été observées pendant des expériences :

- Vitesse de Croissance Semi-polaire : 1 nm/s
- Vitesse de Croissance dans la direction +c : 2,5 nm/s c'est-à-dire, environ 2,5 fois plus vite que la croissance dans la direction semi-polaire.

Certains détails supplémentaires concernant la mise en œuvre de l'invention sont fournis ci-dessous. Ces détails concernent en particulier la croissance de la couche épitaxiale à base de GaN pour les vitesses de croissance mentionnées ci-dessus

- Matériaux : rapport molaire V/III entre 100 - 2000. Ce rapport doit être maintenu aussi bas que possible. Selon un mode de réalisation préféré, le rapport V/III est approximativement égal à 440, mais des résultats similaires peuvent être obtenus avec des valeurs inférieures à 440 et peuvent atteindre des valeurs jusqu'à 2000. Ces valeurs dépendent également des configurations et des capacités de débit massique dans les réacteurs MOCVD (dépôt en phase vapeur par procédé chimique organométallique). Des expériences ont été conduites avec un réacteur à épitaxie Thomas Swan à commande directe (CCS pour Close Coupled Showerhead) fabriqué par AIXTRON AG.
- Température : De manière avantageuse, la température est maintenue au-dessus de 1000 °C. Ceci permet d'améliorer la qualité du cristal. Des températures inférieures peuvent donner des facettes ondulées.
- Pression : de préférence, la pression sera maintenue entre 50-700 mbar. Cependant, il s'est avéré que la pression ne constitue pas un paramètre crucial qui dépend des capacités du réacteur.

Ces conditions de croissance permettent d'améliorer la direction de la croissance semi-polaire et permet, en conséquence, d'obtenir les cristaux sur la surface du substrat.

Selon un mode de réalisation non limitatif, le motif obtenu grâce à l'invention peut présenter les dimensions suivantes :

- Le pas p1 de la rainure en V 320 : Ce pas p1 peut également être défini comme la période pour le premier niveau de lithographie. De préférence, il est compris dans une plage telle que 50 nm $\leq$ p1 $\leq$ 15 $\mu$m. Ceci permet de faciliter le traitement sur des grandes zones tout en permettant une coalescence efficace. Le pas p1 des rainures 320 est la largeur 454 d'une rainure plus la distance qui sépare deux rainures consécutives. Le pas p1 est mesuré dans un plan parallèle au fond du substrat 310, c'est-à-dire horizontalement sur les figures décrites.

- Le pas p2 des tranchées 450 : Ce pas p2 peut également être défini comme la période du second niveau de lithographie. Typiquement, p2 est choisi pour être 2,5 fois plus petit que p1. Par exemple, si p1 est choisi pour être égal à 10 $\mu$m, alors p2 doit être proche de 4 $\mu$m $\pm$ 30 %. De manière avantageuse, ce rapport garantit une coalescence simultanée dans toutes les directions. Par conséquent, selon un mode de réalisation préféré, le pas des rainures en V 320 et le pas des tranchées 450 sont ajustés en conséquence. Le pas p2 des tranchées 450 est la largeur d'une tranchée plus la distance qui sépare deux tranchées consécutives 450. Le pas p2 est mesuré dans une plan parallèle au fond du substrat 310, c'est-à-dire horizontalement sur les figures décrites.

- Dimension de la facette à partir de laquelle on procédera à une croissance épitaxiale d'un nitrure obtenu avec l'un au moins parmi les matériaux suivants : gallium (Ga), indium (In) et aluminium (Al) : les dimensions de la facette vont de 50 nm jusqu'à une valeur de rainure en V complète qui dépend du pas et de l'ouverture.

Toute réduction de contact entre le substrat et la couche de matériau à base de V-N ayant été mise en croissance réduira le nombre de défauts générés. En termes de répartition spatiale des chaines de dislocations, cette configuration de substrat permet de réduire le nombre de défauts générés initiaux par suite du contact d'interface substrat/matériau V-N.

De plus, le procédé de l'invention permet la formation d'un plus grand nombre de zones cristallines avant la coalescence ce qui signifie plus d'inflexion des dislocations le long du plan basal, et par conséquent moins de dislocations qui se propagent vers la surface comme l'expliquent les publications de P. Vennéguès et al. "Réduction mechanisms for defect densities in the V-N material using one- or two-step epitaxial lateral overgrowth methods" (Mécanismes de réduction de la densité des défauts dans les matériaux V-N à l'aide de procédés de surcroissance latérale épitaxiale en une ou deux étape(s)), JOURNAL OF APPLIED PHYSICS, AMERICAN INSTITUTE OF PHYSICS. NEW YORK, US, vol. 87, no. 9, 1 Mai 2000 (2000-05-01), pages 4175-4181.

En ce qui concerne la répartition des défauts d'empilement basal (BSF), et étant donné qu'il s'est avéré que les BSF sont générés à partir de la direction de croissance -c, la création de la structure en pilier de l'invention entraine une nouvelle réduction de l'extension dans le plan -c et par conséquent une réduction des BSF.

À partir de la description ci-dessus, il apparait clairement que l'invention permet de réduire les défauts cristallographiques quand on fait croître une couche épitaxiale d'un nitrure obtenu avec l'un au moins parmi les matériaux suivants :gallium (Ga), indium (In) et aluminium (Al) sur un substrat de silicium.

L'invention permet ainsi d'obtenir des LED vertes ayant un meilleur rendement.

L'invention n'est pas limitée aux modes de réalisation décrits ci-dessus et s'étend à tous les modes de réalisation couverts par les revendications.

## Revendications

1.  Procédé permettant d'obtenir au moins une couche semi-polaire (480) d'au moins un matériau comprenant du nitrure (N) et au moins l'un parmi le gallium (Ga), indium (In) et aluminium (Al) sur une surface supérieure d'un substrat cristallin (310), ledit procédé comprenant les étapes suivantes:

    - obtenir, sur la surface supérieure du substrat cristallin (310), une pluralité de rainures parallèles (320, 410, 420) qui s'étendent principalement dans une première direction, chaque rainure (320, 410, 420) étant continue, chaque rainure (320, 410, 420) comprenant au moins deux facettes inclinées opposées (330, 331) une (330) desdites deux facettes opposées (330, 331) présentant une orientation cristalline {111} ;
    - masquer la surface supérieure du substrat cristallin (310) de telle sorte que les facettes (331) opposées auxdites facettes (330) présentant une orientation cristalline {111} soient masquées et que lesdites facettes (330) présentant une orientation cristalline {111} ne soient pas masquées ;
    - croissance épitaxiale de ladite couche semi-polaire (480) ; le procédé comprenant également les étapes suivantes exécutées après l'étape d'obtention de la pluralité de rainures parallèles (320, 410, 420) et avant l'étape de croissance épitaxiale de ladite couche semi-polaire (480):

    - graver une pluralité de tranchées parallèles (450) qui s'étendent dans une seconde direction ayant subi une rotation par rapport à ladite première direction des rainures (320, 410, 420), en interrompant ainsi les rainures continues (320, 410, 420) de manière à former une matrice (335) de facettes individuelles (330') présentant chacune une orientation cristalline {111} et de manière à ce que lesdites facettes individuelles soient formées à partir desdites rainures et soient séparées par lesdites tranchées; les tranchées (450) et les rainures (320, 410, 420) présentant chacune un fond (451), le fond (451) des tranchées (450) se trouvant à la même profondeur ou en dessous du fond (411, 421) des rainures (320, 410, 420); de sorte que pendant ladite étape de croissance épitaxiale, ledit matériau croît uniquement à partir desdites facettes individuelles (330') qui présentent une orientation cristalline {111} et qui forment ladite matrice (335).

2.  Procédé selon la revendication précédente, dans lequel le rapport molaire V/III dudit matériau comprenant du nitrure (N) et au moins l'un parmi le gallium (Ga), l'Indium (In) et l'aluminium (Al) est compris entre 100 et 2000.

3.  Procédé selon la revendication précédente, dans lequel le rapport molaire V/III dudit matériau comprenant du nitrure (N) et au moins l'un parmi le gallium (Ga), l'Indium (In) et l'aluminium (Al) est compris entre 300 et 500 et de préférence entre 380 et 420.

4.  Procédé selon l'une quelconque des revendications précédentes, dans lequel l'étape de masquage de la surface supérieure du substrat cristallin (310), de telle sorte que les facettes (331) opposées auxdites facettes (330) présentant une orientation cristalline {111} sont masquées et que lesdites facettes (330) présentant une orientation cristalline {111} ne sont pas masquées, comprend le dépôt d'une couche de masquage (460) d'un matériau comprenant au moins l'un parmi : le dioxyde de silicium (SiO2), le nitrure de silicium (SiN), le nitrure de titane (TiN).

5.  Procédé selon l'une quelconque des revendications précédentes, dans lequel ladite première direction, selon laquelle ladite pluralité de rainures parallèles (320, 410, 420) s'étend, correspond à une direction commune au plan de ladite surface supérieure du substrat cristallin (310) et au plan <111>.

6.  Procédé selon l'une quelconque des revendications précédentes, dans lequel le dépôt d'une couche de masquage (460) est un dépôt angulaire exécuté de telle sorte que toute la surface supérieure du substrat cristallin (310) soit masquée, à l'exception desdites facettes (330) qui présentent une orientation cristalline {111}.

7. Procédé selon l'une quelconque des revendications précédentes, dans lequel ledit matériau est un matériau à base de nitrure de gallium (GaN).

8. Procédé selon l'une quelconque des revendications précédentes, dans lequel ledit matériau à base de nitrure de gallium (GaN) est composé d'alliages quelconques qui comprennent en outre de l'aluminium (Al) et de l'indium (In).

9. Procédé selon l'une quelconque des revendications 1 à 6, dans lequel ledit matériau est l'un quelconque parmi : le nitrure de gallium (GaN), le nitrure d'indium (InN), le nitrure d'aluminium (AlN), le nitrure d'aluminium gallium (AlGaN), le nitrure d'indium gallium (InGaN), le nitrure d'aluminium gallium indium (AlGaInN), le nitrure d'aluminium indium (AlInN).

10. Procédé selon l'une quelconque parmi les revendications précédentes, dans lequel les rainures sont des rainures complètes en forme de V (410), dans lesquelles les deux facettes inclinées opposées (330, 331) se rejoignent au fond de la rainure (410) et définissent ensemble le fond (411) de la rainure (410).

11. Procédé selon l'une quelconque des revendications 1 à 7, dans lequel les rainures (420) comprennent un fond plat (421) et dans lequel les deux facettes opposées (330, 331) se rejoignent au fond (421) de la rainure (420).

12. Procédé selon l'une quelconque des revendications précédentes, dans lequel pendant ladite étape de croissance épitaxiale, ledit matériau croît sous forme de germes dont la coalescence forme ladite couche semi-polaire (480) et dans lequel les dimensions des tranchées (450) et des rainures (320) sont configurées pour permettre une croissance et de préférence une coalescence des germes (480) sans contact avec, ou tout au moins sans contact avec tout, le fond (451) des tranchées (450).

13. Procédé selon l'une quelconque des revendications précédentes, dans lequel pendant ladite étape de croissance épitaxiale, ledit matériau croît sous forme de germes dont la coalescence forme ladite couche semi-polaire (480) et dans lequel les dimensions des tranchées (450) et des rainures (320) sont configurées pour permettre une croissance et de préférence une coalescence des germes (480) avec préservation d'un espace (500) entre au moins certains des germes et le fond (451) des tranchées (450).

14. Procédé selon l'une quelconque des revendications précédentes, dans lequel la longueur desdites facettes (330) présentant une orientation cristalline {111} est supérieure à 50 nm.

15. Procédé selon l'une quelconque des revendications précédentes, dans lequel lesdites première et seconde directions définissent un angle (470) qui est supérieur à 40° et qui est de préférence compris entre 50° et 90° et de préférence compris entre 60° et 90°.

16. Procédé selon l'une quelconque des revendications précédentes, dans lequel les tranchées (450) sont gravées perpendiculairement aux rainures initiales (320, 410, 420).

17. Procédé selon l'une quelconque des revendications précédentes, dans lequel les tranchées (450) ont une profondeur (452) qui est égale ou supérieure à la profondeur des rainures (320, 410, 420).

18. Procédé selon l'une quelconque des revendications précédentes, dans lequel les tranchées (450) ont des parois latérales verticales.

19. Procédé selon l'une quelconque des revendications précédentes, dans lequel la pluralité de rainures parallèles (320, 410, 420) présente un pas p1 qui est compris entre 50 nm et 20 $\mu$m et de préférence compris entre 75 nm et 15 $\mu$m.

20. Procédé selon la revendication précédente, dans lequel la pluralité de tranchées parallèles (450) présentent un pas p2 qui est supérieur à $\dfrac{p1*0.8}{2.5}$ et de préférence supérieur à $\dfrac{p1*0.9}{2.5}$.

21. Procédé selon l'une quelconque des deux revendications précédentes, dans lequel la pluralité de tranchées parallèles (450) présente un pas p2 qui est inférieur à 1,1*p1 et de préférence inférieur à p1.

22. Procédé selon l'une quelconque des revendications précédentes, dans lequel, pendant l'étape de la croissance épitaxiale, la température du substrat (310) est maintenue entre 700 et 1300 °C et de préférence entre 900 et 1100 °C.

23. Procédé selon l'une quelconque des revendications précédentes, dans lequel, pendant l'étape de la croissance épitaxiale, la pression est maintenue entre 30 mbar et 1500 mbar et de préférence entre 50 mbar et 700 mbar.

**24.** Procédé selon l'une quelconque des revendications précédentes, dans lequel la pluralité de rainures parallèles (320, 410, 420) présentent un pas p1, dans lequel la pluralité de tranchées parallèles (450) présentent un pas p2 qui est compris entre 0,9*p1 et 1,1*p1 et dans lequel le petit angle (470) défini par lesdites première et seconde directions est supérieur à 40° et est de préférence supérieur à 60°.

**25.** Procédé selon l'une quelconque des revendications précédentes, dans lequel ladite étape de croissance épitaxiale comprend :

- une première croissance épitaxiale d'un matériau à base de nitrure d'aluminium (AIN) à partir desdites facettes individuelles (330') qui présentent une orientation cristalline {111} et qui forment ladite matrice (335) ;
- au moins une seconde croissance épitaxiale d'un matériau à base de nitrure de gallium (GaN) (480) à partir dudit matériau à base de nitrure d'aluminium (AIN) après croissance épitaxiale.

**26.** Procédé selon l'une quelconque des revendications précédentes, dans lequel ladite étape de gravure d'une pluralité de tranchées parallèles est effectuée après l'étape d'obtention de la pluralité de rainures parallèles (320, 410, 420) et avant l'étape de masquage de la surface supérieure du substrat cristallin (310), de telle sorte que les facettes opposées auxdites facettes (330) présentant une orientation cristalline {111} soient masquées.

**27.** Procédé de fabrication d'au moins une diode électroluminescente (LED) configurée de manière à émettre au moins dans la plage du vert des longueurs d'ondes, comprenant le procédé selon l'une quelconque des revendications précédentes permettant d'obtenir une couche semi-polaire (480) d'au moins un matériau comprenant un nitrure (N) et au moins l'un parmi le gallium (Ga), l'Indium (In) et l'aluminium (Al) sur une surface supérieure d'un substrat cristallin (310).

**28.** Dispositif microélectronique comprenant un substrat cristallin (310) et une couche semi-polaire (480) d'au moins un matériau comprenant du nitrure (N) et au moins l'un parmi le gallium (Ga), l'Indium (In) et l'aluminium (Al) sur une surface supérieure dudit substrat cristallin (310),

- le substrat comprenant une pluralité de rainures parallèles (320, 410, 420) qui s'étendent dans une première direction, chaque rainure (320, 410, 420) comprenant au moins deux facettes inclinées opposées (330, 331) formant chacune une bande continue qui s'étend dans ladite première direction, une desdites deux facettes opposées (330) présentant une orientation cristalline {111} ;

le substrat comprenant également une pluralité de tranchées parallèles (450) qui s'étendent dans une seconde direction ayant subi une rotation par rapport à ladite première direction ;
la combinaison de la pluralité des rainures parallèles (320, 410, 420) et la pluralité des tranchées parallèles (450) définit une matrice (335) de facettes individuelles (330') présentant une orientation cristalline {111}, de manière à ce que lesdites facettes individuelles soient formées à partir desdites rainures et soient séparées par lesdites tranchées ;
les tranchées (450) et les rainures (320, 410, 420) présentant chacune un fond (411, 421, 451), le fond (451) des tranchées (450) se trouvant à la même profondeur ou en dessous du fond (411, 421) des rainures (320, 410, 420) ;
ledit matériau (480) étant en contact direct avec les facettes individuelles (330) présentant une orientation cristalline {111} ;
le dispositif comprenant également une couche de masquage (460) disposée entre le substrat (310) et ledit matériau (480) et qui couvre l'intégralité de la surface supérieure du substrat (310) à l'exception des facettes individuelles (330') présentant une orientation cristalline {111}.

**29.** Dispositif microélectronique selon la revendication précédente, dans lequel la pluralité de rainures parallèles (320, 410, 420) présentent un pas p1, dans lequel la pluralité de tranchées parallèles (450) présentent un pas p2 qui est compris entre 0,8*p1 et 1,2*p1 et dans lequel le petit angle (470) défini par lesdites première et seconde directions est supérieur à 40°, et est de préférence supérieur à 60°.

**30.** Diodes électroluminescentes (LED) comprenant un dispositif microélectronique selon l'une quelconque des deux revendications précédentes.

**Patentansprüche**

**1.** Verfahren, mit dem mindestens eine halbpolare Schicht (480) aus mindestens einem Material, das Nitrid (N) und mindestens eines von Gallium (Ga), Indium (In) und Aluminium (Al) umfasst, auf einer Oberseite eines kristallinen Substrats (310) erhalten werden kann, wobei das Verfahren die folgenden Schritte umfasst:

- Erhalten, auf der Oberseite des kristallinen Substrats (310), mehrerer paralleler Rillen (320, 410, 420), die sich hauptsächlich in einer ersten Richtung erstrecken, wobei jede Rille (320, 410, 420) kontinuierlich ist, wobei jede Rille (320, 410, 420) mindestens zwei gegenüberliegende geneigte Facetten (330, 331) aufweist, wobei eine (330) der beiden gegenüberliegenden Facetten (330, 331) eine {111}-Kristallorientierung aufweist;
- Maskieren der Oberseite des kristallen Substrats (310), so dass die den Facetten (330) mit {111}-Kristallorientierung gegenüberliegenden Facetten (331) maskiert werden und die Facetten (330) mit {111}-Kristallorientierung nicht maskiert werden;
- epitaktisches Aufwachsenlassen der halbpolaren Schicht (480);

wobei das Verfahren auch die folgenden Schritte umfasst, die nach dem Schritt des Erhaltens der mehreren parallelen Rillen (320, 410, 420) und vor dem Schritt des epitaktischen Aufwachsenlassens der halbpolaren Schicht (480) ausgeführt werden:

- Ätzen mehrerer paralleler Gräben (450), die sich in einer zweiten Richtung erstrecken, die in Bezug auf die erste Richtung der Rillen (320, 410, 420) gedreht ist, so dass die kontinuierlichen Rillen (320, 410, 420) unterbrochen werden, um eine Matrix (335) aus einzelnen Facetten (330') jeweils mit einer {111}-Kristallorientierung zu bilden, und so dass die einzelnen Facetten auf der Basis der Rillen gebildet und durch die Gräben getrennt werden; wobei die Gräben (450) und die Rillen (320, 410, 420) jeweils einen Boden (451) haben, wobei der Boden (451) der Gräben (450) in derselben Tiefe wie oder tiefer als der Boden (411, 421) der Rillen (320, 410, 420) liegt;

so dass während des Schrittes des epitaktischen Aufwachsenlassens das Material nur aus den einzelnen Facetten (330') hervorwächst, die eine {111}-Kristallorientierung aufweisen und die Matrix (335) bilden.

2. Verfahren nach dem vorhergehenden Anspruch, wobei das Molverhältnis V/III des Materials, das Nitrid (N) und mindestens eines von Gallium (Ga), Indium (In) und Aluminium (Al) umfasst, zwischen 100 und 2000 liegt.

3. Verfahren nach dem vorhergehenden Anspruch, wobei das Molverhältnis V/III des Materials, das Nitrid (N) und mindestens eines von Gallium (Ga), Indium (In) und Aluminium (Al) umfasst, zwischen 300 und 500 und vorzugsweise zwischen 380 und 420 liegt.

4. Verfahren nach einem der vorhergehenden Ansprüche, wobei der Schritt des Maskierens der Oberseite des kristallinen Substrats (310), so dass die den Facetten (330) mit {111}-Kristallorientierung gegenüberliegenden Facetten (331) maskiert werden und die Facetten (330) mit {111}-Kristallorientierung nicht maskiert werden, das Absetzen einer Maskierungsschicht (460) aus einem Material umfasst, das mindestens eines von Siliciumdioxid (SiO2), Siliciumnitrid (SiN), Titannitrid (TiN) umfasst.

5. Verfahren nach einem der vorhergehenden Ansprüche, wobei die erste Richtung, in der sich die mehreren parallelen Rillen (320, 410, 420) erstrecken, einer der Ebene der Oberseite des kristallinen Substrats (310) und der Ebene <111> gemeinsamen Richtung entspricht.

6. Verfahren nach einem der vorhergehenden Ansprüche, wobei das Absetzen einer Maskierungsschicht (460) ein winkelförmiges Absetzen ist, das so ausgeführt ist, dass die gesamte Oberseite des kristallinen Substrats (310) maskiert wird, mit Ausnahme der Facetten (330), die eine {111}-Kristallorientierung aufweisen.

7. Verfahren nach einem der vorhergehenden Ansprüche, wobei das Material ein Material auf der Basis von Galliumnitrid (GaN) ist.

8. Verfahren nach einem der vorhergehenden Ansprüche, wobei das Material auf der Basis von Galliumnitrid (GaN) aus beliebigen Legierungen besteht, die zusätzlich Aluminium (Al) und Indium (In) umfassen.

9. Verfahren nach einem der Ansprüche 1 bis 6, wobei das Material ein beliebiges von Galliumnitrid (GaN), Indiumnitrid (InN), Aluminiumnitrid (AlN), Aluminiumgalliumnitrid (AlGaN), Indiumgalliumnitrid (InGaN), Aluminiumgalliumindiumnitrid (AlGaInN), Aluminiumindiumnitrid (AlInN) ist.

10. Verfahren nach einem der vorhergehenden Ansprüche, wobei die Rillen vollständige V-förmige Rillen (410) sind, in denen sich die beiden gegenüberliegenden geneigten Facetten (330, 331) am Boden der Rille (410) vereinigen und zusammen den Boden (411) der Rille (410) definieren.

11. Verfahren nach einem der Ansprüche 1 bis 7, wobei die Rillen (420) einen flachen Boden (421) aufweisen und wobei sich die beiden gegenüberliegenden Facetten (330, 331) am Boden (421) der Rille (420) vereinigen.

12. Verfahren nach einem der vorhergehenden Ansprüche, wobei während des Schrittes des epitaktischen Aufwachsenlassens das Material in Form von Keimen wächst, deren Koaleszenz die halbpolare Schicht (480) bildet, und wobei die Abmessungen der Gräben (450) und Rillen (320) so konfiguriert sind, dass sie ein Wachstum und vorzugsweise eine Koaleszenz der Keime (480) ohne Kontakt mit dem, zumindest ohne Kontakt mit dem gesamten Boden (451) der Gräben (450) ermöglichen.

13. Verfahren nach einem der vorhergehenden Ansprüche, wobei während des Schrittes des epitaktischen Aufwachsenlassens das Material in Form von Keimen wächst, deren Koaleszenz die halbpolare Schicht (480) bildet, und wobei die Abmessungen der Gräben (450) und Rillen (320) konfiguriert sind, um ein Wachstum und vorzugsweise eine Koaleszenz der Keime (480) unter Beibehaltung eines Raums (500) zwischen mindestens einigen der Keime und dem Boden (451) der Gräben (450) ermöglichen.

14. Verfahren nach einem der vorhergehenden Ansprüche, wobei die Länge der Facetten (330) mit {111}-Kristallorientierung größer als 50 nm ist.

15. Verfahren nach einem der vorhergehenden Ansprüche, wobei die erste und die zweite Richtung einen Winkel (470) definieren, der größer als 40° ist und vorzugsweise zwischen 50° und 90° und vorzugsweise zwischen 60° und 90° liegt.

16. Verfahren nach einem der vorhergehenden Ansprüche, wobei die Gräben (450) lotrecht zu den Anfangsrillen (320, 410, 420) geätzt werden.

17. Verfahren nach einem der vorhergehenden Ansprüche, wobei die Gräben (450) eine Tiefe (452) haben, die gleich der oder größer als die Tiefe der Rillen (320, 410, 420) ist.

18. Verfahren nach einem der vorhergehenden Ansprüche, wobei die Gräben (450) vertikale Seitenwände haben.

19. Verfahren nach einem der vorhergehenden Ansprüche, wobei die mehreren parallelen Rillen (320, 410, 420) eine Teilung p1 zwischen 50 nm und 20 pm und vorzugsweise zwischen 75 nm und 15 μm aufweisen.

20. Verfahren nach dem vorhergehenden Anspruch, wobei die mehreren parallelen Gräben (450) eine Teilung p2 aufweisen, die größer als $\frac{p1*0.8}{2.5}$ und vorzugsweise kleiner als $\frac{p1*0.9}{2.5}$ ist.

21. Verfahren nach einem der beiden vorhergehenden Ansprüche, wobei die mehreren parallelen Gräben (450) eine Teilung p2 aufweisen, die kleiner als 1,1*p1 und vorzugsweise kleiner als p1 ist.

22. Verfahren nach einem der vorhergehenden Ansprüche, wobei während des Schrittes des epitaktischen Aufwachsenlassens die Temperatur des Substrats (310) zwischen 700 und 1300 °C und vorzugsweise zwischen 900 und 1100 °C gehalten wird.

23. Verfahren nach einem der vorhergehenden Ansprüche, wobei während des Schrittes des epitaktischen Aufwachsenlassens der Druck zwischen 30 mbar und 1500 mbar und vorzugsweise zwischen 50 mbar und 700 mbar gehalten wird.

24. Verfahren nach einem der vorhergehenden Ansprüche, wobei die mehreren parallelen Rillen (320, 410, 420) eine Teilung p1 aufweisen, wobei die mehreren parallelen Gräben (450) eine Teilung p2 zwischen 0,9*p1 und 1,1*p1 aufweisen und wobei der durch die erste und die zweite Richtung definierte kleine Winkel (470) größer als 40° und vorzugsweise größer als 60° ist.

25. Verfahren nach einem der vorhergehenden Ansprüche, wobei der Schritt des epitaktischen Aufwachsenlassens Folgendes umfasst:

    - ein erstes epitaktisches Aufwachsenlassen eines Materials auf der Basis von Aluminiumnitrid (AIN) aus den einzelnen Facetten (330'), die eine {111}-Kristallorientierung aufweisen und die die Matrix (335) bilden;
    - mindestens ein zweites epitaktisches Aufwachsenlassen eines Materials (480) auf der Basis von Galliumnitrid (GaN) aus dem Material auf der Basis von Aluminiumnitrid (AIN) nach dem epitaktischen Wachstum.

26. Verfahren nach einem der vorhergehenden Ansprüche, wobei der Schritt des Ätzens mehrerer paralleler Gräben nach dem Schritt des Erhaltens der mehreren parallelen Rillen (320, 410, 420) und vor dem Schritt des Maskierens der Oberseite des kristallinen Substrats (310) durchgeführt wird, so dass die den Facetten (330) gegenüberliegenden Facetten mit {111}-Kristallorientierung maskiert werden.

27. Verfahren zur Herstellung mindestens einer Leuchtdiode (LED), konfiguriert zum Emittieren mindestens im grünen Wellenlängenbereich, das das Verfahren nach einem der vorhergehenden Ansprüche umfasst, mit dem eine halbpolare Schicht (480) aus mindestens einem Material erhalten werden kann, das ein Nitrid (N) und mindestens eines von Gallium (Ga), Indium (In) und Aluminium (Al) umfasst, auf einer Oberseite eines kristallinen Substrats (310).

28. Mikroelektronische Vorrichtung, die ein kristallines Substrat (310) und eine halbpolare Schicht (480) aus mindestens einem Material umfasst, das Nitrid (N) und mindestens eines von Gallium (Ga), Indium (In) und Aluminium (Al) umfasst, auf einer Oberseite des kristallinen Substrats (310),

- wobei das Substrat mehrere parallele Rillen (320, 410, 420) aufweist, die sich in einer ersten Richtung erstrecken, wobei jede Rille (320, 410, 420) mindestens zwei gegenüberliegende geneigte Facetten (330, 331) aufweist, die jeweils ein kontinuierliches Band bilden, das sich in der ersten Richtung erstreckt, wobei eine der beiden gegenüberliegenden Facetten (330) eine {111}-Kristallorientierung aufweist;

wobei das Substrat auch mehrere parallele Gräben (450) aufweist, die sich in einer zweiten Richtung erstrecken, die in Bezug auf die erste Richtung gedreht ist; die Kombination der mehreren parallelen Rillen (320, 410, 420) und der mehreren parallelen Gräben (450) definiert eine Matrix (335) aus einzelnen Facetten (330') mit einer {111}-Kristallorientierung, so dass die einzelnen Facetten aus den Rillen gebildet und durch die Gräben getrennt werden; wobei die Gräben (450) und die Rillen (320, 410, 420) jeweils einen Boden (411, 421, 451) aufweisen, wobei sich der Boden (451) der Gräben (450) in derselben Tiefe wie oder tiefer als der Boden (411, 421) der Rillen (320, 410, 420) befindet; wobei das Material (480) in direktem Kontakt mit den einzelnen Facetten (330) ist, die eine {111}-Kristallorientierung aufweisen; wobei die Vorrichtung auch eine Maskierungsschicht (460) umfasst, die zwischen dem Substrat (310) und dem Material (480) angeordnet ist und die die gesamte Oberseite des Substrats (310) mit Ausnahme der einzelnen Facetten (330') mit {111}-Kristallorientierung bedeckt.

29. Mikroelektronische Vorrichtung nach dem vorhergehenden Anspruch, wobei die mehreren parallelen Rillen (320, 410, 420) eine Teilung p1 aufweisen, wobei die mehreren parallelen Gräben (450) eine Teilung p2 zwischen 0,8*p1 und 1,2*p1 aufweisen, und wobei der durch die erste und die zweite Richtung definierte kleine Winkel (470) größer als 40° und vorzugsweise größer als 60° ist.

30. Leuchtdioden (LEDs), die eine mikroelektronische Vorrichtung nach einem der beiden vorhergehenden Ansprüche umfassen.

**Claims**

1. A method for obtaining at least one semi-polar layer (480) of at least one material comprising nitride (N) and at least one of gallium (Ga), indium (In) and aluminium (Al) on an upper surface of a crystalline substrate (310), said method comprising the steps of:

- obtaining, on the upper surface of the crystalline substrate (310), a plurality of parallel grooves (320, 410, 420) which extend mainly in a first direction, each groove (320, 410, 420) being continuous, each groove (320, 410, 420) comprising at least two opposite inclined facets (330, 331), at least one (330) of said two opposing facets (330, 331) having a crystal orientation {1 1 1};
- masking the upper surface of the crystalline substrate (310) so that the facets (331) opposite to said facets (330) having a crystal orientation {1 1 1} are masked and that said facets (330) having a crystal orientation {1 1 1} are not masked;
- epitaxially growth of said semipolar layer (480);

the method further comprising the following steps performed after the step of obtaining the plurality of parallel grooves (320, 410, 420) and before the epitaxial growth step of said semi-polar layer (480):

- etching a plurality of parallel trenches (450) extending in a second direction rotated with respect to said first direction of the grooves (320, 410, 420), thereby interrupting the continuous grooves (320, 410, 420) so as to form a matrix (335) of individual facets (330') each having a crystal orientation {111} and such that said individual facets are formed from said trenches and are separated by said trenches; the trenches (450) and grooves (320, 410, 420) each having a bottom (451), the bottom (451) of the trenches (450) being at the same depth or below the bottom (411, 421) of the grooves (320, 410, 420);

such that during said epitaxial growth step, said material grows only from said individual facets (330') which have a crystal orientation {1 1 1} and which form said matrix (335).

2. The method according to the preceding claim, wherein the molar ratio V/III of said material comprising nitride (N) and at least one of gallium (Ga), indium (In) and aluminium (Al) is between 100 and 2000.

3. The method according to the preceding claim, wherein the molar ratio V/III of said material comprising nitride (N) and at least one of gallium (Ga), indium (In) and aluminium (Al) is between 300 and 500 and preferably between 380 and 420.

4. The method according to any one of the preceding claims, wherein the step of masking the upper surface of the crystalline substrate (310), such that the facets (331) opposed to said facets (330) having a crystalline orientation {1 1 1} are masked and that said facets (330) having a crystal orientation {1 1 1} are not masked, comprises depositing a masking layer (460) of a material comprising at least one of: silicon dioxide (SiO2), silicon nitride (SiN), titanium nitride (TiN).

5. The method according to any one of the preceding claims, wherein said first direction, in which said plurality of parallel grooves (320, 410, 420) extend, corresponds to a direction common to the plane of said upper surface of the crystalline substrate (310) and to the plane <1 1 1>.

6. The method according to any one of the preceding claims, wherein the deposition of a masking layer (460) is an angular deposition performed such that the entire upper surface of the crystalline substrate (310) is masked, except for said facets (330) having a crystal orientation {1 1 1}.

7. The method according to any one of the preceding claims, wherein said material is a gallium nitride (GaN) material.

8. The method according to any one of the preceding claims, wherein said gallium nitride (GaN) material is composed of any alloys which further include aluminium (Al) and indium (In).

9. The process according to any one of claims 1 to 6, wherein said material is any of: gallium nitride (GaN), indium nitride (InN), aluminium nitride (AlN), aluminium gallium nitride (AlGaN), indium gallium nitride (InGaN), aluminium gallium indium nitride (AlGaInN), aluminium indium nitride (AlInN).

10. The method according to any one of the preceding claims, wherein the grooves are V-shaped complete grooves (410) in which the two opposite inclined facets (330, 331) meet at the bottom of the groove (410) and together define the bottom (411) of the groove (410).

11. The method according to any one of claims 1 to 7, wherein the grooves (420) comprise a flat bottom (421) and wherein the two opposite facets (330, 331) meet at the bottom (421) of the groove (420).

12. The process according to any one of the preceding claims, wherein during said epitaxial growth step, said material grows as seeds whose coalescence forms said semipolar layer (480) and wherein the dimensions of the trenches (450) and grooves (320) are configured to allow growth and preferably coalescence of the seeds (480) without contact with, or at least no contact with all of, the bottom (451) of the trenches (450).

13. The process according to any one of the preceding claims, wherein during said epitaxial growth step, said material grows in the form of seeds whose coalescence forms said semi-polar layer (480) and wherein the dimensions of the trenches (450) and grooves (320) are configured to allow growth and preferably germ coalescence (480) with preservation of a gap (500) between at least some of the seeds and the bottom (451) of the trenches (450).

14. The method according to any one of the preceding claims, wherein the length of said facets (330) having a crystal orientation {1 1 1} is greater than 50 nm.

15. A method according to any one of the preceding claims, wherein said first and second directions define an angle (470) which is greater than 40° and which is preferably between 50° and 90° and preferably between 60° and 90°.

16. The method according to any one of the preceding claims, wherein the trenches (450) are engraved perpendicular to the initial grooves (320, 410, 420).

17. The method according to any one of the preceding claims, wherein the trenches (450) have a depth (452) that is equal to or greater than the depth of the grooves (320, 410, 420).

18. The method according to any one of the preceding claims, wherein the trenches (450) have vertical sidewalls.

19. The method according to any one of the preceding claims, wherein the plurality of parallel grooves (320, 410, 420) has a pitch p1 which is between 50 nm and 20 $\mu$m and preferably between 75 nm and 15 $\mu$m.

20. The method according to the preceding claim, wherein the plurality of parallel trenches (450) have a pitch p2 which is greater than $\dfrac{p1 * 0.8}{2.5}$ and preferably greater than $\dfrac{p1 * 0.9}{2.5}$.

**21.** The method according to any one of the two preceding claims, wherein the plurality of parallel trenches (450) have a pitch p2 which is less than 1,1*p1 and preferably less than p1.

**22.** The method according to any one of the preceding claims, wherein, during the step of epitaxial growth, the temperature of the substrate (310) is maintained between 700 and 1300 °C and preferably between 900 and 1100 °C.

**23.** The method according to any one of the preceding claims, wherein, during the step of epitaxial growth, the pressure is maintained between 30 mbar and 1500 mbar and preferably between 50 mbar and 700 mbar.

**24.** The method according to any one of the preceding claims, wherein the plurality of parallel grooves (320, 410, 420) have a pitch p1, wherein the plurality of parallel trenches (450) have a pitch p2 which is between 0,9*p1 and 1,1*p1 and wherein the small angle (470) defined by said first and second directions is greater than 40 ° and is preferably greater than 60 °.

**25.** The method according to any one of the preceding claims, wherein said epitaxial growth step comprises:

- a first epitaxial growth of an aluminium nitride material (AlN) from said individual facets (330') which have a crystal orientation {111} and which form said matrix (335);
- at least a second epitaxial growth of a gallium nitride (GaN) material (480) from said aluminium nitride (AlN) material after epitaxial growth.

**26.** The method according to any one of the preceding claims, wherein said step of etching a plurality of parallel trenches is performed after the step of obtaining the plurality of parallel grooves (320, 410, 420) and before the step of masking the upper surface of the crystalline substrate (310), so that the facets opposed to said facets (330) having a crystal orientation {1 1 1} are masked.

**27.** A method of manufacturing at least one light emitting diode (LED) configured so as to emit at least in the green wavelength range, comprising the method of any one of the preceding claims for obtaining a semipolar layer (480) of at least one material comprising a nitride (N) and at least one of gallium (Ga), indium (In) and aluminium (Al) on an upper surface of a crystalline substrate (310).

**28.** A microelectronic device comprising a crystalline substrate (310) and a semi-polar layer (480) of at least one material comprising nitride (N) and at least one of gallium (Ga), indium (In) and aluminium (Al) on an upper surface of said crystalline substrate (310),

- the substrate comprising a plurality of parallel grooves (320, 410, 420) which extend in a first direction, each groove (320, 410, 420) comprising at least two opposite inclined facets (330, 331) each forming a continuous band which extends in said first direction, one of said two opposite facets (330) having a crystal orientation {1 1 1};

the substrate also comprising a plurality of parallel trenches (450) which extend in a second direction rotated with respect to said first direction;
the combination of the plurality of parallel grooves (320, 410, 420) and the plurality of parallel trenches (450) defines a matrix (335) of individual facets (330') having a crystal orientation {1 1 1}; such that said individual facets are formed from said trenches and are separated by said trenches;
the trenches (450) and the grooves (320, 410, 420) each having a bottom (411, 421, 451), the bottom (451) of the trenches (450) being at the same depth or below the bottom (411, 421) of the grooves (320, 410, 420);
said material (480) being in direct contact with the individual facets (330) having a crystal orientation {1 1 1};
the device also comprising a masking layer (460) disposed between the substrate (310) and said material (480) and covering the entire upper surface of the substrate (310) except for the individual facets (330') having a crystalline orientation {1 1 1}.

**29.** Microelectronic device according to the preceding claim, wherein the plurality of parallel grooves (320, 410, 420) have a pitch p1, wherein the plurality of parallel trenches (450) have a pitch p2 which is between 0.8*p1 and 1,2*p1 and wherein the small angle (470) defined by said first and second directions is greater than 40°, and is preferably greater than 60°.

**30.** Light-emitting diodes (LEDs) comprising a microelectronic device according to either one of the two preceding claims.

Figure 1

Figure 2

Figure 3a

Figure 3b

Figure 3c

Figure 3d

430

320

310

410

411

420

421

## Figure 4a

330  331  330  331

## Figure 4b

440
470
330
444
442
331

Figure 4c

440
454
450
470
452
451

Figure 4d

456

458

Figure 4e

330'    P    460

335    330'

330'

451

411

Figure 4f

Figure 4g

Figure 4h

Figure 5a

Figure 5b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012276722 A1

- US 2012135557 A1

**Littérature non-brevet citée dans la description**

- **T. HIKOSAKA et al.** Fabrication and properties of semi-polar (1-101) and (11-22) InGaN/GaN light emitting diodes on patterned Si substrates. *phys. stat. sol. (c),* 2008, vol. 5 (6), 2234-2237

- **HONDA et al.** Growth of (1 0 1) GaN on a 7-degree off-oriented (0 0 1)Si substrate by selective MOVPE. *J. Cryst. Growth,* 2002, vol. 242, 82-6

- JOURNAL OF APPLIED PHYSICS. AMERICAN INSTITUTE OF PHYSICS, 01 Mai 2000, vol. 87, 4175-4181